# EUROPEAN PATENT SPECIFICATION

(11) **EP 4 184 900 B1**
(45) Date of publication and mention of the grant of the patent: **12.11.2025**
(21) Application number: 21866972.9
(22) Date of filing: 09.07.2021
(51) Int. Cl.: H04M 1/02, F16C 11/04, G06F 1/16

(54) **HINGE STRUCTURE COMPRISING HELICAL GEAR, AND ELECTRONIC DEVICE COMPRISING SAME**
SCHARNIERSTRUKTUR MIT SCHRÄGVERZAHNTEM ZAHNRAD UND ELEKTRONISCHE VORRICHTUNG DAMIT
STRUCTURE DE CHARNIÈRE COMPRENANT UN ENGRENAGE HÉLICOÏDAL, ET DISPOSITIF ÉLECTRONIQUE LE COMPRENANT

(30) Priority: 08.09.2020 KR 20200114845
(43) Date of publication of application: 24.05.2023
(73) Proprietor: Samsung Electronics Co., Ltd., Suwon-si, Gyeonggi-do 16677 (KR)
(72) Inventor: PARK, Daehyeong, Suwon-si, Gyeonggi-do 16677 (KR); HAN, Yonghwa, Suwon-si, Gyeonggi-do 16677 (KR); LEE, Giyun, Suwon-si, Gyeonggi-do 16677 (KR)
(74) Representative: HGF
(86) International application number: PCT/KR2021/008800
(87) International publication number: WO 2022/055105

(56) References cited:
- CN-U- 209 781 447
- CN-U- 209 781 447
- CN-U- 211 018 886
- US-A1- 2016 060 927
- US-A1- 2017 235 337
- US-B1- 10 352 354
- US-B1- 9 464 471
- US-B1- 9 677 308

## Description

### [Technical Field]

Various embodiments of the disclosure described herein relate to a hinge structure including a helical gear.

### [Background Art]

A portable electronic device such as a smartphone may provide various functions, such as telephone calls, video playback, Internet searches, and the like, based on various types of applications. A user may want to use the aforementioned various functions through a wider screen. However, portability may be decreased with an increase in screen size. Accordingly, a foldable portable electronic device capable of increasing portability using a foldable structure is being developed.

In the foldable electronic device, a hinge structure may be connected to adjacent housings and may perform a rotary motion while supporting the housings during rotation of the housings through a predetermined angle. US 2016/0060927 A1 discloses an electronic device having a double-shaft hinge. US 10354354 B1 discloses a flexible display device with a positionable hinge mechanism. CN 209781447U discloses an umbrella-shaped helical gear transmission double-shaft hinge and electronic equipment.

### [Disclosure]

### [Technical Problem]

A plurality of gear structures associated with the operation of connecting the housings separated on both sides may be disposed in the hinge structure included in the foldable electronic device. In this case, due to the plurality of gear structures, a space required for the hinge structure may be increased, and therefore it is difficult to make the foldable electronic device light and slim. In addition, in the case of the hinge structure including the plurality of gear structures, one side of a display may be damaged by the plurality of gear structures in a folded state of the electronic device.

Various embodiments of the disclosure provide a hinge structure and an electronic device including a helical gear capable of simplifying a gear structure.

Various embodiments of the disclosure provide a hinge structure and an electronic device including the same, the hinge structure being capable of preventing damage to a display by securing a gap of a specified value or more between one side of the display (e.g., a folded portion) and a gear structure in a folded state of the electronic device.

### [Technical Solution]

An electronic device (or, a portable electronic device, a portable communication device, a foldable electronic device, or a foldable electronic device having a communication function) according to various embodiments of the disclosure includes a foldable display, a first housing, a second housing, and a hinge structure that connects the first housing and the second housing. The hinge structure includes a first rotary member coupled (or fastened) to the first housing, a second rotary member coupled (or fastened) to the second housing, a first arm part that rotates along the first rotary member based on a sliding operation when the first rotary member rotates, a second arm part that rotates along the second rotary member based on a sliding operation when the second rotary member rotates, a fixed bracket on which the first rotary member and the second rotary member are seated, a helical gear seated on one side of the fixed bracket, a first rotary shaft coupled to the first arm part, a first shaft gear disposed on one side of the first rotary shaft and engaged (or coupled) with one side of the helical gear, a second rotary shaft coupled to the second arm part, and a second shaft gear disposed on one side of the second rotary shaft and engaged (or coupled) with an opposite side of the helical gear.

An electronic device according to an embodiment includes a first rotary member coupled (or fastened) to a first housing, a second rotary member coupled (or fastened) to a second housing, a first arm part that rotates along the first rotary member based on a sliding operation when the first rotary member rotates, a second arm part that rotates along the second rotary member based on a sliding operation when the second rotary member rotates, a fixed bracket on which the first rotary member and the second rotary member are seated, a helical gear seated on one side of the fixed bracket, a first rotary shaft coupled to the first arm part, a first shaft gear disposed on one side of the first rotary shaft and engaged (or coupled) with one side of the helical gear, a second rotary shaft coupled to the second arm part, and a second shaft gear disposed on one side of the second rotary shaft and engaged (or coupled) with an opposite side of the helical gear.

### [Advantageous Effects]

The hinge structure including the helical gear and the electronic device including the same according to the various embodiments may simplify the gear structure related to the interlocking of the housings, thereby reducing manufacturing costs and securing stability through the simplified structure.

Furthermore, the hinge structure and the electronic device including the same according to the embodiments may prevent damage to the display by securing the gap between the display and the hinge structure.

Various other aspects and effects provided by the arm structure, the hinge structure, and the electronic device including the same according to the various embodiments may be mentioned depending on embodiments in the detailed description.

### [Description of Drawings]

FIG. 1 is an exploded perspective view of an electronic device according to various embodiments.
FIG. 2A is a view illustrating an example of a rear side of the electronic device according to various embodiments.
FIG. 2B is a view illustrating an example of a folded state of the electronic device according to various embodiments.
FIG. 3 is a view illustrating a state in which some components of the electronic device are removed according to various embodiments.
FIG. 4 is a view illustrating one example of a front side of a hinge structure of the electronic device including a helical gear according to various embodiments.
FIG. 5 is an exploded perspective view of the hinge structure according to various embodiments.
FIG. 6 is a view illustrating an example of a gear structure according to an embodiment.
FIG. 7 is a view illustrating an example of various cut sections of the gear structure according to an embodiment.
FIG. 8 is a view illustrating an example of a fixed bracket and a center bracket according to an embodiment.
FIG. 9 is a view illustrating an example of a coupled state of the fixed bracket, the center bracket, and the helical gear according to an embodiment.
FIG. 10 is a view illustrating an example of a coupling of at least some components of the hinge structure according to an embodiment.
FIG. 11 is a view illustrating an example of a section of some components of the electronic device according to an embodiment.
FIG. 12 is a view illustrating a hinge structure of an electronic device according to another embodiment.
FIG. 13 is a view illustrating a hinge structure of an electronic device according to another embodiment.
FIG. 14 is a view illustrating another example of a cam shape according to various embodiments.
FIG. 15 is a view illustrating one example of a contact state of some ridges of a cam and a cam structure according to various embodiments.

### [Mode for Invention]

Hereinafter, various embodiments of the disclosure will be described with reference to accompanying drawings.

In the disclosure, the expressions "have", "may have", "include" and "comprise", or "may include" and "may comprise" used herein indicate existence of corresponding features (e.g., components such as numeric values, functions, operations, or parts ) but do not exclude presence of additional features.

In the disclosure, the expressions "A or B", "at least one of A or/and B", or "one or more of A or/and B", and the like may include any and all combinations of one or more of the associated listed items. For example, the term "A or B", "at least one of A and B", or "at least one of A or B" may refer to all of the case (1) where at least one A is included, the case (2) where at least one B is included, or the case (3) where both of at least one A and at least one B are included.

The terms, such as "first", "second", and the like used in the disclosure may be used to refer to various components regardless of the order and/or the priority and to distinguish the relevant components from other components, but do not limit the components. For example, "a first user device" and "a second user device" indicate different user devices regardless of the order or priority. For example, without departing the scope of the disclosure, a first component may be referred to as a second component, and similarly, a second component may be referred to as a first component.

It will be understood that when a component (e.g., a first component) is referred to as being "(operatively or communicatively) coupled with/to" or "connected to" another component (e.g., a second component), it may be directly coupled with/to or connected to the other component or an intervening component (e.g., a third component) may be present. In contrast, when a component (e.g., a first component) is referred to as being "directly coupled with/to" or "directly connected to" another component (e.g., a second component), it should be understood that there are no intervening component (e.g., a third component).

According to the situation, the expression "configured to" used in the disclosure may be used as, for example, the expression "suitable for", "having the capacity to", "designed to", "adapted to", "made to", or "capable of". The term "configured to" must not mean only "specifically designed to" in hardware. Instead, the expression "a device configured to" may mean that the device is "capable of" operating together with another device or other parts. For example, a "processor configured to (or set to) perform A, B, and C" may mean a dedicated processor (e.g., an embedded processor) for performing a corresponding operation or a generic-purpose processor (e.g., a central processing unit (CPU) or an application processor) which performs corresponding operations by executing one or more software programs which are stored in a memory device.

Terms used in the disclosure are used to describe specified embodiments and are not intended to limit the scope of the disclosure. The terms of a singular form may include plural forms unless otherwise specified. All the terms used herein, which include technical or scientific terms, may have the same meaning that is generally understood by a person skilled in the art. It will be further understood that terms, which are defined in a dictionary and commonly used, should also be interpreted as is customary in the relevant related art and not in an idealized or overly formal unless expressly so defined in various embodiments of the disclosure. In some cases, even if terms are terms which are defined in the disclosure, they may not be interpreted to exclude embodiments of the disclosure.

An electronic device according to various embodiments of the disclosure may include at least one of, for example, smartphones, tablet personal computers (PCs), mobile phones, video telephones, electronic book readers, desktop PCs, laptop PCs, netbook computers, workstations, servers, personal digital assistants (PDAs), portable multimedia players (PMPs), Motion Picture Experts Group (MPEG-1 or MPEG-2) Audio Layer 3 (MP3) players, mobile medical devices, cameras, or wearable devices. According to various embodiments, the wearable device may include at least one of an accessory type (e.g., watches, rings, bracelets, anklets, necklaces, glasses, contact lens, or head-mounted-devices (HMDs)), a fabric or garment-integrated type (e.g., an electronic apparel), a body-attached type (e.g., a skin pad or tattoos), or a bio-implantable type (e.g., an implantable circuit).

Hereinafter, electronic devices according to various embodiments will be described with reference to the accompanying drawings. In the disclosure, the term "user" may refer to a person who uses an electronic device or may refer to a device (e.g., an artificial intelligence electronic device) that uses the electronic device.

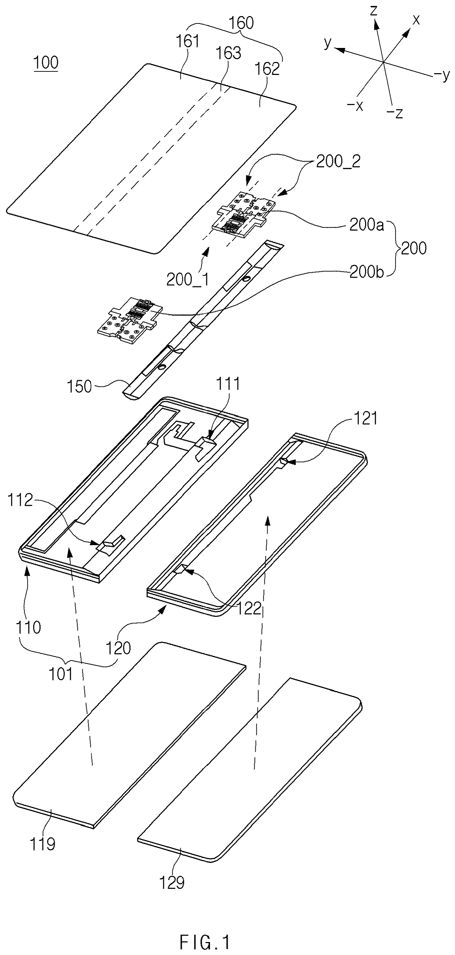

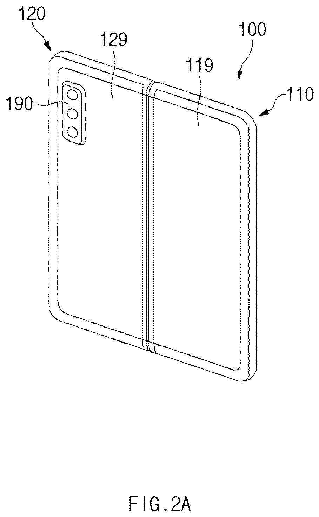

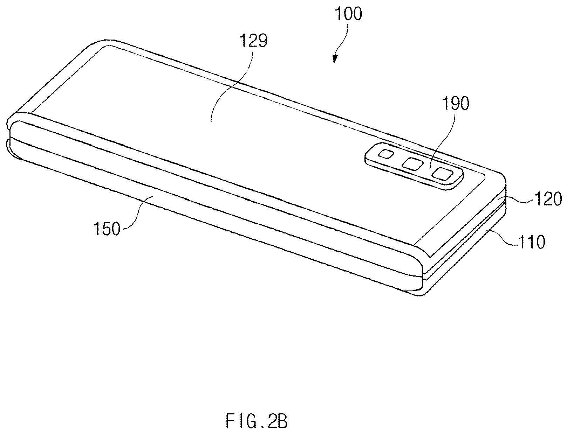

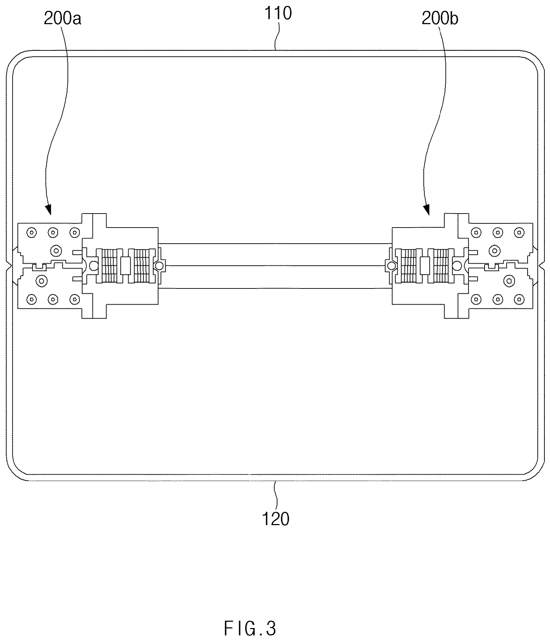

FIG. 1 is an exploded perspective view of an electronic device according to various embodiments, FIG. 2A is a view illustrating an example of a rear side of the electronic device according to various embodiments, and FIG. 2B is a view illustrating an example of a folded state of the electronic device according to various embodiments. FIG. 3 is a view illustrating a state in which some components of the electronic device are removed according to various embodiments. For example, FIG. 3 is a view illustrating a state in which a hinge structure is observed by exclusion of a display configuration from the electronic device of FIG. 1.

Referring to FIGS. 1 to 3, the electronic device 100 according to an embodiment (or, a foldable electronic device, a flexible display device, or a flexible & foldable electronic device) may include a housing 101 (e.g., a first housing 110 and a second housing 120), a hinge housing 150, a hinge structure 200 (e.g., a first hinge structure 200a and a second hinge structure 200b), and a display 160 (or, a flexible display or a display module) at least partially disposed in a front direction (e.g., the z-axis direction) of the hinge structure 200. Additionally or alternatively, the electronic device 100 may further include a first cover 119 that covers at least a portion of a rear surface (e.g., a surface facing in the -z-axis direction) of the first housing 110 and a second cover 129 that covers at least a portion of a rear surface (e.g., a surface facing in the -z-axis direction) of the second housing 120. In another case, the first cover 119 may integrally form a rear surface with the first housing 110, and the second cover 129 may integrally form a rear surface with the second housing 120. According to various embodiments, a device element (e.g., at least one of a camera, at least one sensor, a battery, a printed circuit board, at least one processor mounted on the printed circuit board, a memory, a communication circuit, or an external connection interface) related to driving the electronic device 100 may be disposed in at least one of a region between the first cover 119 and the first housing 110 or a region between the second cover 129 and the second housing 120.

The housing 101 may constitute at least one pair of housings that are rotatable about predetermined axes. For example, according to the present invention, the housing 101 includes the first housing 110 and the second housing 120. Depending on an arrangement, the first housing 110 may be disposed to be continuous with the second housing 120 (e.g., when a central portion 163 of the display 160 is unfolded flat or when the housing 101 is in an unfolded state), or may be disposed side by side with the second housing 120. Alternatively, when the central portion 163 of the display 160 is folded, one surface of the first housing 110 may be disposed to face one surface of the second housing 120.

For example, at least a portion of the first housing 110 may be formed of a metallic material, or at least a portion of the first housing 110 may be formed of a non-metallic material. To support at least a portion of the display 160, the first housing 110 may be formed of a material having a predetermined stiffness. One region of the display 160 (e.g., at least part of a first portion 161 of the display 160 and at least a portion of one side of the central portion 163) may be disposed on at least a portion of a front surface of the first housing 110. At least a portion of the first housing 110 may be attached to the first portion 161 of the display 160. Alternatively, at least a portion of the periphery of the front surface of the first housing 110 may be attached to the periphery of the first portion 161 of the display 160. In another case, at least a portion of the front surface (e.g., a surface facing in the z-axis direction) of the first housing 110 may be attached to at least part of the first portion 161 of the display 160. In this regard, an adhesive layer may be disposed in (or, an adhesive material may be applied to) at least a portion between the first housing 110 and the first portion 161 of the display 160. At least a portion of the inside of the first housing 110 may be provided in a hollow form or may be coupled with the first cover 119 to form a hollow, and electronic components (e.g., a printed circuit board, and components, such as at least one processor, at least one memory, and a battery, which are mounted on the printed circuit board) required to drive the electronic device 100 may be disposed in the hollow.

According to various embodiments, edges of the first housing 110 (e.g., the remaining three edges other than the edge facing the second housing 120 in the unfolded state of the electronic device 100) may protrude above a bottom surface of a central portion of the housing (e.g., at least a portion of a surface visible from the z-axis toward the -z-axis) by a specified height to surround at least a periphery on one side of the display 160. Alternatively, sidewalls may be disposed on at least one of the edges of the first housing 110 to at least partially face the periphery of the display 160. The sidewalls formed on at least a portion of the periphery of the first housing 110 may be formed on the remaining three edges other than the edge facing the second housing 120 and may have a specified height. According to various embodiments, the sidewalls may be removed from one side edges (e.g., edges in the x-axis and -x-axis directions) among the edges of the first housing 110, and the heights of bottom surfaces of the one side edges may be equal to or smaller than the height of a bottom surface of a central portion. For example, the thickness of the first housing 110 may be decreased toward the one side edges (e.g., the edges in the x-axis and -x-axis directions) from the central portion of the first housing 110. According to an embodiment, the one side edges (e.g., the edges in the x-axis and -x-axis directions) may have a shape curved with a predetermined curvature in one direction (e.g., in the x-axis direction or the -x-axis direction from the central portion of the first housing 110) when viewed in the direction from the z-axis to the -z-axis. The expression of the edge may include at least a side surface of the first housing 110 (e.g., a surface visible in the direction from the x-axis to the -x-axis). According to various embodiments, the edge may have a width smaller than the width of the central portion of the first housing 110 and may include a width from the side surface of the first housing 110 toward the central portion of the first housing 110 within a predetermined distance. According to various embodiments, in a case in which the edge is curved, the edge may include at least from an x-axis or -x-axis end of a flat bottom region of the central portion of the first housing 110 (or, a portion where bending starts) to the side surface (e.g., a surface visible in the direction from the x-axis to the -x-axis).

An edge portion of the first housing 110 that faces the second housing 120 when the electronic device 100 is in the unfolded state may include a depression (or, a portion thinner than an adjacent surrounding portion), at least a portion of which has a predetermined curvature such that at least a portion of the hinge housing 150 is disposed in the depression. For example, the first housing 110 may include, on the edge portion facing the second housing 120, a first step portion 111 in which a portion of the first hinge structure 200a located in the hinge housing 150 is located and a second step portion 112 in which a portion of the second hinge structure 200b located in the hinge housing 150 is disposed.

According to various embodiments, depending on an arrangement, the second housing 120 may be disposed side by side with the first housing 110, or may be disposed such that at least one surface thereof faces one surface of the first housing 110 (e.g., the surface on which the display 160 is disposed). For example, the second housing 120 may be formed of the same material as that of the first housing 110. The second housing 120 may be disposed to be symmetrical to the first housing 110 in a left/right direction or an up/down direction, and at least a portion of the remaining region of the display 160 other than the region disposed on the first housing 110 (e.g., at least part of a second portion 162 of the display 160 and at least a portion of an opposite side of the central portion 163) may be disposed on a front surface of the second housing 120. At least a portion of the second housing 120 may be attached to the second portion 162 of the display 160. Alternatively, the periphery of the front surface of the second housing 120 may be attached to the periphery of the second portion 162 of the display 160. In another case, at least one side of the front surface (e.g., a surface facing in the z-axis direction) of the second housing 120 may be attached to one side of the second portion 162 of the display 160. In this regard, an adhesive layer may be disposed in (or, an adhesive material may be applied to) at least a portion between the second housing 120 and the second portion 162 of the display 160. Similarly to the first housing 110, at least a portion of the inside of the second housing 120 may be provided in a hollow form or may be coupled with the second cover 129 to form a hollow, and electronic components required to drive the electronic device 100 may be disposed in the hollow. According to various embodiments, a camera 190 may be disposed on the rear surface of the second housing 120, and with regard to the arrangement of the camera 190, the second cover 129 may have a hole (or an opening) formed therein in which the camera 190 is disposed.

According to various embodiments, edges of the second housing 120 (e.g., the remaining three edges other than the edge facing the first housing 110) may protrude above a bottom surface of a central portion of the second housing 120 by a specified height to surround a periphery on an opposite side of the display 160. Alternatively, similarly to the sidewalls formed on the first housing 110, sidewalls may be disposed on at least one of the edges of the second housing 120 to at least partially face the periphery of the display 160. The sidewalls formed on at least a portion of the periphery of the second housing 120 may be formed on the remaining three edges other than the edge facing the first housing 110 and may have a specified height. According to various embodiments, at least some of the remaining three edges (e.g., edges in the x-axis and -x-axis directions) may not have separate sidewalls and may be formed so as to be curved with a predetermined curvature.

According to various embodiments, a portion of the second housing 120 that faces the first housing 110 may include a depression (or, a portion of the second housing 120 that is thinner than an adjacent surrounding portion), at least a portion of which has a predetermined curvature such that the hinge housing 150 is disposed in the depression. For example, the second housing 120 may include, on the edge portion facing the first housing 110, a third step portion 121 in which a portion of the hinge housing 150 having the first hinge structure 200a mounted thereon is disposed and a fourth step portion 122 in which a portion of the hinge housing 150 having the second hinge structure 200b mounted thereon is disposed.

According to various embodiments, the electronic device 100 may include at least one sensor disposed on one side of the inside of the first housing 110 or the second housing 120. The sensor may include, for example, at least one of a proximity sensor, an illuminance sensor, an iris sensor, an image sensor (or, a camera), or a fingerprint sensor.

According to various embodiments, depending on the folded or unfolded state of the electronic device 100, the hinge housing 150 may be hidden by one side of the first housing 110 and one side of the second housing 120 (e.g., an unfolded state of the housing 101), or may be exposed to the outside (e.g., a folded state of the housing 101). For example, at least a portion of the hinge housing 150 may be hidden by the first housing 110 and the second housing 120 when the first housing 110 and the second housing 120 are disposed side by side. When one surface of the first housing 110 and one surface of the second housing 120 are disposed to face each other, at least a portion of the hinge housing 150 may be exposed to the outside from between one edge of the first housing 110 and one edge of the second housing 120 (e.g., the edges of the first housing 110 and the second housing 120 that face each other in the unfolded state). According to various embodiments, the degree to which the hinge housing 150 is exposed in the unfolded state of the electronic device 100 may be lower than the degree to which the hinge housing 150 is exposed in the folded state. The hinge housing 150 may at least partially have an empty space therein and may include sidewalls disposed to at least partially close opposite edges (e.g., edges in the x-axis direction and the -x-axis direction). At least one boss fastened (or coupled) with the first hinge structure 200a and the second hinge structure 200b may be disposed on at least a portion of an inner surface of the hinge housing 150.

According to various embodiments, at least a portion of the display 160 may have flexibility. According to an embodiment, the display 160 may include the first portion 161 or the first region disposed on the first housing 110, the second portion 162 or the second region disposed on the second housing 120, and the central portion 163 or the central region to which the first housing 110 and the second housing 120 are adjacent in the unfolded state of the electronic device 100 and that corresponds to the position of the hinge structure 200. According to various embodiments, the entire display 160 may have flexibility. Alternatively, at least part of the central portion 163 of the display 160 may have flexibility. The central portion 163 of the display 160 may be disposed such that the first housing 110 and the second housing 120 are not attached thereto. For example, the central portion 163 of the display 160 may be spaced apart from a front surface (e.g., a surface facing in the z-axis direction) of the hinge structure 200 in a folding operation of the electronic device 100. The first portion 161 of the display 160 may be attached to at least a portion of the first housing 110, and the second portion 162 of the display 160 may be attached to at least a portion of the second housing 120. In this regard, an adhesive layer may be disposed in at least a partial region between the display 160 and the first housing 110, and an adhesive layer may be disposed in at least a partial region between the display 160 and the second housing 120. The display 160 may include various layers. For example, the display 160 may include an outer protective layer (or, a glass layer or a polymer layer) that has a predetermined transparency and has a specified size or more, a display panel layer that is disposed under the outer protective layer and that displays a screen, and a first rear layer disposed under the display panel layer. The first rear layer may include a shock absorbing layer (or, an embo) or a heat radiating layer (or, a metal sheet layer). Additionally or alternatively, the first rear layer may further include an electromagnetic induction panel (e.g., a digitizer). According to various embodiments, the display 160 may further include a second rear layer disposed under the first rear layer. The second rear layer may include at least one metal layer (or, metal sheet), at least a portion of which is formed of a metallic material. The second rear layer may include a specified pattern (e.g., a lattice pattern or a slit pattern) such that at least a portion thereof can be bent. Alternatively, at least a portion of the second rear layer may be formed of another flexible material (e.g., a polymer material, rubber, or a leather material).

According to various embodiments, at least one hinge structure 200 may be disposed based on the x-axis direction. For example, the hinge structure 200 may include the first hinge structure 200a and the second hinge structure 200b. The hinge structure 200 may include first portions 200_1 disposed inside the hinge housing 150 and second portions 200_2 corresponding to peripheral structures that are disposed over the hinge housing 150 or do not overlap the hinge housing 150 based on the z-axis (e.g., a structure coupled with the first housing 110 and the second housing 120). Among the first portions 200_1 of the hinge structure 200, at least a portion of the first hinge structure 200a may be disposed on a first inside of the hinge housing 150 (e.g., a region biased in the x-axis direction within the hinge housing 150). Among the first portions 200_1 of the hinge structure 200, at least a portion of the second hinge structure 200b may be disposed on a second inside of the hinge housing 150 (e.g., a region biased in the -x-axis direction within the hinge housing 150). At least parts of the second portions 200_2 of the hinge structure 200 may rotate in response to rotation operations of the first housing 110 and the second housing 120. At least one of the first hinge structure 200a or the second hinge structure 200b according to an embodiment may include a helical gear.

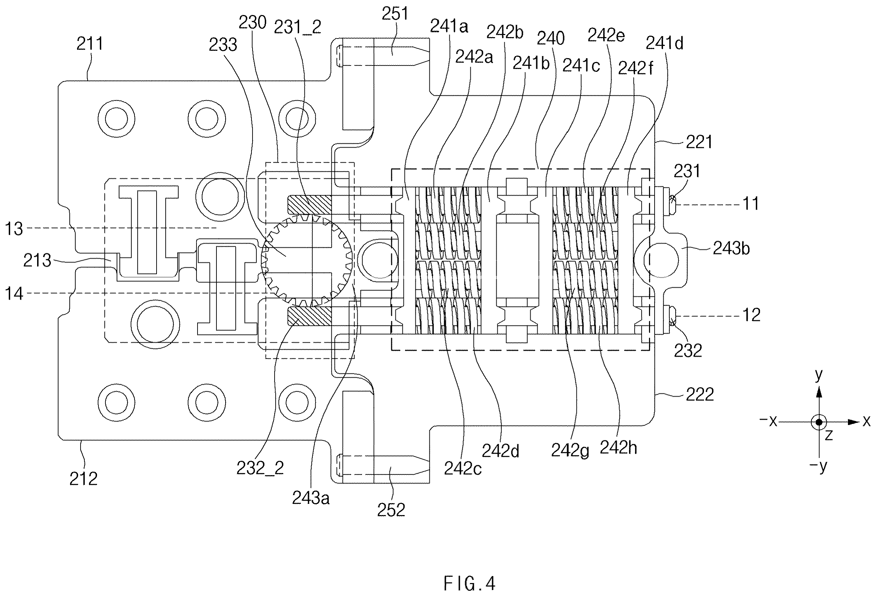

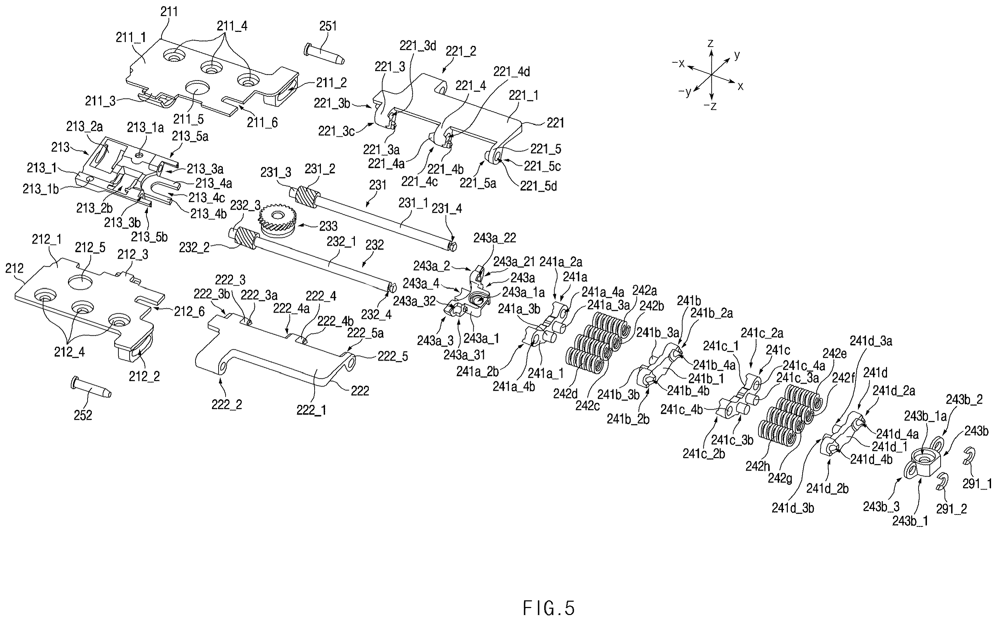

FIG. 4 is a view illustrating one example of a front side of a hinge structure of the electronic device including a helical gear according to various embodiments, and FIG. 5 is an exploded perspective view of the hinge structure according to various embodiments.

Referring to FIGS. 4 and 5, the electronic device 100 according to an embodiment may include a plurality of hinge structures 200, and the first hinge structure 200a and the second hinge structure 200b may have the same structure and form. The following description will be given based on the first hinge structure 200a. Although FIG. 1 illustrates the structure in which the first hinge structure 200a and the second hinge structure 200b are disposed on the hinge housing 150, the disclosure is not limited thereto, and three or more hinge structures may be mounted on the hinge housing 150.

According to various embodiments, the first hinge structure 200a may include rotary members 211 and 212, a fixed bracket 213, arm parts 221 and 222, a gear structure 230 (e.g., a helical gear 233, a first shaft gear 231_2 (or, a first shaft gear), and a second shaft gear 232_2 (or, a second shaft gear)), and a detent structure 240. Additionally or alternatively, the first hinge structure 200a may include a center bracket 243a for fixing the gear structure 230 and a shaft bracket 243b for fixing the detent structure 240.

According to various embodiments, the rotary members 211 and 212 may support at least a portion of the display 160. The rotary members 211 and 212 may include the first rotary member 211 coupled to one side of the fixed bracket 213 and the second rotary member 212 coupled to an opposite side of the fixed bracket 213. The first rotary member 211 may rotate (e.g., in the clockwise or counterclockwise direction based on the x-axis) within a first angle range while being coupled to one side of the fixed bracket 213. The second rotary member 212 may rotate (e.g., in the counterclockwise or clockwise direction based on the x-axis) within a second angle range while being coupled to one side of the fixed bracket 213. The magnitudes of the first angle range and the second angle range may be the same as each other, and the directions of the first angle range and the second angle range may be opposite to each other. When the electronic device 100 is in the unfolded state, an edge of the first rotary member 211 that faces in the -y-axis direction may be disposed adjacent to an edge of the second rotary member 212 that faces in the y-axis direction. When the electronic device 100 is in the folded state, an upper surface (e.g., a surface facing in the z-axis direction) of the first rotary member 211 and an upper surface (e.g., a surface facing in the z-axis direction) of the second rotary member 212 may be disposed to face each other. The first rotary member 211 may rotate about a third axis 13 (or, a virtual axis) within a predetermined angle range (e.g., the range of 0 degrees (the angle in the unfolded state of the display 160) to 100 degrees or the range of 0 degrees to 95 degrees). The second rotary member 212 may rotate about a fourth axis 14 (or, a virtual axis) within a predetermined angle range (e.g., the range of 0 degrees to -100 degrees or the range of 0 degrees to -95 degrees). The third axis 13 and the fourth axis 14 may be located to be spaced apart from each other by a predetermined gap. The third axis 13 and the fourth axis 14 may be located above a first axis 11 and a second axis 12 based on the z-axis.

The first rotary member 211 may include a first rotary body 211_1, a first slide hole (or first slide opening) 211_2 formed at one end (e.g., an end in the - x-axis direction) of the first rotary body 211_1, a first rail 211_3 (or, a first rotary rail) formed at an opposite end (e.g., an end in the -y-axis direction) of the first rotary body 211_1, and a first housing coupling hole (or a first housing coupling opening) 211_4 used to couple the first rotary member 211 with the first housing (e.g., the first housing 110 of FIG. 1).

According to various embodiments, at least a portion of a surface of the first rotary body 211_1 that faces in the z-axis direction may be formed to be flat, and at least a portion of a surface of the first rotary body 211_1 that faces in the -z-axis direction may also be formed to be entirely flat. With respect to the illustrated drawings, at a right end (e.g., an end in the x-axis direction) of the first rotary body 211_1, the first slide hole 211_2 may be formed to face in a lower direction (e.g., the - z-axis direction), and at an end (e.g., an end in the -y-axis direction) of the first rotary body 211_1, the first rail 211_3 may be disposed to face toward a lower surface (e.g., a surface facing in the -z-axis direction). At least one first housing coupling hole 211_4 used to couple the first rotary member 211 with the first housing 110 may be disposed in the first rotary body 211_1. Although a form in which three first housing coupling holes 211_4 are disposed is illustrated in the drawings, the disclosure is not limited thereto. For example, two or more first housing coupling holes 211_4 may be formed. The two or more first housing coupling holes 211_4 may be disposed to be spaced apart from the first rotary body 211_1. According to various embodiments, at least one first through-hole 211_5 that exposes a hole (or opening) 213_1a formed in the fixed bracket 213 in the z-axis direction and into which a coupling member such as a screw is inserted may be disposed in the first rotary body 211_1. A plurality of first through-holes 211_5 may be provided.

According to various embodiments, the first slide hole 211_2 may be disposed at an opposite end (e.g., an end in the x-axis direction) of the first rotary body 211_1 and may be disposed at the bottom of the first rotary body 211_1. The first slide hole 211_2 may be formed to be longer in a first direction (e.g., the y-axis direction) than in a third direction (e.g., the x-axis direction). Accordingly, a first fastening part 251 inserted into the first slide hole 211_2 may slide in the first slide hole 211_2 in any one of the y-axis direction and the -y-axis direction. The first slide hole 211_2 may be disposed to face a surface of the first arm part 221 that faces in one direction (e.g., a surface disposed in the -x-axis direction). At least a partial region of the first slide hole 211_2 may be aligned with a hole (or an opening) formed in a first connecting part 221_2 of the first arm part 221. Accordingly, at least a portion of the first fastening part 251 may be disposed in the first slide hole 211_2 and the hole formed in the first connecting part 221_2.

According to various embodiments, the first rail 211_3 may be disposed at an end of the first rotary body 211_1 that faces in the y-axis direction and may be disposed at the bottom of the first rotary body 211_1. At least a portion of the first rail 211_3 may have an arc shape with a predetermined angle. The first rail 211_3 may be inserted into a first rail hole (or a first rail opening) 213_2a (or, a rail type hole or a rail groove) disposed in the fixed bracket 213 and may rotate along the first rail hole 213_2a within a specified rotation range. According to an embodiment, the rotation range of the first rail 211_3 may be included within the angle of the arc that forms the shape of the first rail 211_3. For example, the rotation range of the first rail 211_3 may be at least a partial range (e.g., a range of 0 degrees to 95 degrees) within the range of -10 degrees to 100 degrees. The first rail 211_3 may perform rotary motion between the -z-axis and the z-axis about the third axis 13 formed by the first rail hole 213a_2a. For example, the first rail 211_3 may rotate about the third axis 13 in the counterclockwise direction while the electronic device 100 is changed from the unfolded state to the folded state and may rotate about the third axis 13 in the clockwise direction while the electronic device 100 is changed from the folded state to the unfolded state.

The first housing coupling hole 211_4 may be formed on one side of the first rotary body 211_1 (e.g., at an edge facing in the y-axis direction) and may be formed through the surface facing in the z-axis direction and the surface facing in the -z-axis direction. In the illustrated drawings, it is exemplified that third first housing coupling holes 211_4 are formed in the first rotary body 211_1. However, the disclosure is not limited to the number of first housing coupling holes 211_4.

A first exposed portion 211_6 may be formed on one side of the first rotary body 211_1 (e.g., in a direction biased in the -y-axis direction among edges in the x-axis direction). The first exposed portion 211_6 may vertically penetrate in the z-axis direction and the -z-axis direction, may be open in the x-axis direction, and may have a U-shape when viewed in the z-axis direction. The first exposed portion 211_6 may be formed such that at least a portion of the first shaft gear 231_2 is exposed to the outside. Alternatively, according to various embodiments, at least a portion of the first shaft gear 231_2 may be disposed above an empty space of the first exposed portion 211_6. By disposing at least a portion of the first shaft gear 231_2 in the first exposed portion 211_6, the electronic device 100 may suppress an increase in the thickness of the electronic device 100 in the z-axis direction, thereby providing a slimmer device structure and securing a space for increasing the z-axis thickness of the first shaft gear 231_2.

The second rotary member 212 may include a second rotary body 212_1, a second slide hole (or second slide opening) 212_2 formed at one end (e.g., an end in the -x-axis direction) of the second rotary body 212_1, a second rail 212_3 (or, a second rotary rail) formed at an opposite end (e.g., an end in the - y-axis direction) of the second rotary body 211_1 to face in the -z-axis direction and coupled to a second rail hole (or second rail opening) 213_2b of the fixed bracket 213 to provide the fourth axis 14, and a second housing coupling hole (or second housing coupling opening) 212_4 used to couple the second rotary member 212 with the second housing (e.g., the second housing 120 of FIG. 1). According to an embodiment, a second through-hole 212_5 may be provided on one side of the second rotary body 212_1. The second through-hole 212_5 may expose a hole (or opening) 213_1b of the fixed bracket 213 in the z-axis direction and may provide a path along which a coupling member is inserted.

The second rotary member 212 may have the same structure as the above-described first rotary member 211 and may be disposed in a structure symmetrical to the first rotary member 211 with respect to the -x-axis and the x-axis. For example, the second rotary body 212_1 of the second rotary member 212 may have a shape and a size that are the same as or similar to those of the first rotary body 211_1 of the first rotary member 211, and the second slide hole 212_2 may have the same size and shape as the first slide hole 211_2. At least a portion of a second fastening part 252 may be inserted into the second slide hole 212_2, and as the second rotary member 212 rotates, the second fastening part 252 may move in the second slide hole 212_2. While being fastened (or coupled) to the second slide hole 212_2, the second fastening part 252 may be fastened (or coupled) to a hole formed in a second connecting part 222_2 of the second arm part 222. Similarly to the first fastening part 251, at least a portion of the second fastening part 252 may have a pin shape. According to various embodiments, a second exposed portion 212_6 similar to the first exposed portion 211_6 may be formed on one side of the second basic body 222_1 (e.g., in a direction biased in the -y-axis direction among edges in the x-axis direction). The second exposed portion 212_6 may vertically penetrate in the z-axis direction and the -z-axis direction, may be open in the x-axis direction, and may have a U-shape when viewed in the z-axis direction. By disposing at least a portion of the second shaft gear 232_2 in the second exposed portion 212_6, the electronic device 100 may suppress an increase in the thickness of the electronic device 100 in the z-axis direction, thereby providing a slimmer device structure and securing a space for increasing the z-axis thickness of the second shaft gear 232_2.

According to various embodiments, at least a portion of the fixed bracket 213 may be fixedly disposed in an empty space of the hinge housing 150. In this regard, at least a portion of the fixed bracket 213 may have a shape corresponding to the empty space of the hinge housing 150, for example, a semicylindrical shape. The fixed bracket 213 may include at least one hole 213_1a and 213_1b into which at least a portion of at least one boss formed on the hinge housing 150 is inserted. The first rail hole 213_2a in which one side of the first rotary member 211 is disposed so as to be rotatable within a predetermined angle range may be formed on one side of the fixed bracket 213, and the second rail hole 213_2b in which one side of the second rotary member 212 is disposed so as to be rotatable within a predetermined angle range may be formed on an opposite side of the fixed bracket 213.

According to an embodiment, the gear structure 230 may be disposed on a front side (an end portion in the x-axis direction) of the fixed bracket 213. In this regard, the fixed bracket 213 may include a plurality of extensions 213_4a, 213 4b, 213_5a, and 213_5b. The plurality of extensions 213_4a, 213_4b, 213_5a, and 213_5b may include, for example, the first extension (or first extension part, or first extension portion) 213_4a that extends from the bottom of the fixed bracket 213 (e.g., a lower portion of the bottom facing in the -z-axis direction) and extends from the y-axis edge of the fixed bracket 213 in the x-axis direction, the second extension (or second extension part, or second extension portion) 213_4b that extends from the bottom of the fixed bracket 213 (e.g., the lower portion of the bottom facing in the -z-axis direction) and extends from the -y-axis edge of the fixed bracket 213 in the x-axis direction and that is spaced apart from the first extension 213_4a by a first distance, the third extension (or third extension part, or third extension portion) 213_5a that extends from the y-axis edge of the fixed bracket 213 in the x-axis direction and that is located in a higher position in the z-axis direction than the first extension 213_4a, and the fourth extension (or fourth extension part, or fourth extension portion) 213_5b that extends from the -y-axis edge of the fixed bracket 213 in the x-axis direction and that is located in a higher position in the z-axis direction than the second extension 213_4b and spaced apart from the third extension 213_5a by a second distance (e.g., a second distance greater than the first distance). An opening 213_4c (or, a recess) into which one side of the helical gear 233 is inserted may be formed between the first extension 213_4a and the second extension 213_4b. Ends of the first extension 213_4a and the second extension 213_4b in the -x-axis direction may be connected to each other, and at least a portion of a section viewed from the z-axis may be formed in a round shape. A first mounting recess 213_3a into which an end of the first shaft gear 231_2 in the -x-axis direction is inserted may be formed in a surface of the fixed bracket 213 facing in the x-axis direction and a portion adjacent to the third extension 213_5a, and a second mounting recess 213_3b into which an end of the second shaft gear 232_2 in the -x-axis direction is inserted may be formed in a surface of the fixed bracket 213 facing in the x-axis direction and a portion adjacent to the fourth extension 213_5b. According to an embodiment, the first mounting recess 213_3a may be biased in the y-axis direction, and the second mounting recess 213_3b may be biased in the -y-axis direction. The first mounting recess 213_3a and the second mounting recess 213_3b may be spaced apart from each other by a third distance (e.g., a distance smaller than the second distance and greater than the first distance).

According to various embodiments, in response to rotation of the rotary members 211 and 212 of the electronic device 100, the arm parts (or, the arm structures) 221 and 222 may rotate about rotational axes (e.g., the first axis 11 and the second axis 22) while sliding relative to the rotary members 211 and 212 and may be engaged (or coupled) with cam members 241a, 241b, 241c, and 241d to implement a detent operation. For example, the arm parts 221 and 222 may be connected, at sides thereof, with the rotary members 211 and 212 through the fastening parts 251 and 252 and may move while sliding along at least parts of lateral portions of the rotary members 211 and 212 in response to rotation of the rotary members 211 and 212. According to an embodiment, the arm parts 221 and 222 may include, for example, the first arm part 221 connected to the first rotary member 211 through the first fastening part 251 and the second arm part 222 connected to the second rotary member 212 through the second fastening part 252.

The first arm part 221 may be fastened (or coupled) with the first rotary member 211 through the first fastening part 251 and may rotate in conjunction with the first rotary member 211 when a hinge operation is performed. According to an embodiment, the first arm part 221 may include a first basic body 221_1, the first connecting part 221_2, a first shaft connecting part 221_3, a second shaft connecting part 221_4, and a third shaft connecting part 221_5.

At least a portion of an upper surface (e.g., a surface facing in the z-axis direction) of the first basic body 221_1 may be formed to be flat. The first connecting part 221_2 may be disposed on at least a portion of a lower surface (e.g., a surface facing in the -z-axis direction) of an upper edge portion (e.g., an end facing in the y-axis direction) of the first basic body 221_1. The first connecting part 221_2 may be formed in a ring or pipe shape having a predetermined thickness. For example, the first connecting part 221_2 may include a hole that is open in the x-axis direction (or, the -x-axis direction) and into which at least a portion of the first fastening part 251 is inserted. In this regard, the hole of the first connecting part 221_2 may have a size similar to the diameter of the first fastening part 251.

The first shaft connecting part 221_3 may be disposed on a lower surface (e.g., a surface facing in the -z-axis direction) of a lower edge (e.g., an end facing in the -y-axis direction) of the first basic body 221_1 and at an edge thereof facing in the -x-axis direction, the third shaft connecting part 221_5 may be disposed on the lower surface (e.g., the surface facing in the -z-axis direction) of the lower edge (e.g., the end facing in the -y-axis direction) of the first basic body 221_1 and at an edge thereof facing in the x-axis direction, and the second shaft connecting part 221_4 may be disposed on the lower surface (e.g., the surface facing in the -z-axis direction) of the lower edge (e.g., the end facing in the -y-axis direction) of the first basic body 221_1 and between the first shaft connecting part 221_3 and the third shaft connecting part 221_5.

The first shaft connecting part 221_3 may include a first arm extension (or first arm extension portion) 221_3c, a first cam structure 221_3a, a first stopper protrusion 221_3b, and a first shaft insertion hole 221_3d. The first arm extension 221_3c may have a tubular shape that extends from the first basic body 221_1 in the -y-axis direction and has the first shaft insertion hole 221_3d formed in a ring shape or a central portion. At least a portion of an upper surface of the first arm extension 221_3c may have the same height as the upper surface of the first basic body 221_1. The first cam structure 221_3a may be formed on one side of the first arm extension 221_3c and may be disposed to face in the x-axis direction. When the first arm part 221 rotates, the first cam structure 221_3a may perform a cam operation based on elastic forces of elastic members (e.g., 242a, 242b, 242c, and 242d) while at least partially making contact with a first cam 241a_2a. The first stopper protrusion 221_3b may be formed on an opposite side of the first arm extension 221_3c and may be disposed to face in the -x-axis direction. The first stopper protrusion 221_3b may be disposed adjacent to a stopper structure disposed on the center bracket 243a. The first stopper protrusion 221_3b may serve to prevent (or limit) rotation of the first arm part 221 through a specified angle or more while making contact with the stopper structure at a specified rotation angle during the rotation of the first arm part 221. The first shaft insertion hole 221_3d may be formed in the first arm extension 221_3c and may be disposed to pass through the x-axis and the -x-axis. At least a portion of a first rotary shaft 231 may be disposed in the first shaft insertion hole 221_3d. In this regard, the first shaft insertion hole 221_3d may have a diameter greater than or equal to the diameter of the first rotary shaft 231.

The second shaft connecting part 221_4 may include a second arm extension (or second arm extension portion) 221_4c, a second cam structure 221_4a, a third cam structure 221_4b, and a second shaft insertion hole 221_4d. The second arm extension 221_4c may be formed to be spaced apart from the first arm extension 221_3c by a predetermined distance in the x-axis direction and may have a tubular shape that extends from the first basic body 221_1 in the -y-axis direction and has the second shaft insertion hole 221_4d formed in a ring shape or a central portion. At least a portion of an upper surface of the second arm extension 221_4c may have the same height as the upper surface of the first basic body 221_1.

The second cam structure 221_4a may be formed on one side of the second arm extension 221_4c and may be disposed to face in the -x-axis direction. When the first arm part 221 rotates, the second cam structure 221_4a may perform a cam operation based on the elastic forces of the elastic members (e.g., 242a, 242b, 242c, and 242d) while at least partially making contact with a third cam 241b_2a. The third cam structure 221_4b may be formed on an opposite side of the second arm extension 221_4c and may be disposed to face in the x-axis direction. When the first arm part 221 rotates, the second cam structure 221_4a may perform a cam operation based on elastic forces of elastic members (e.g., 242e, 242f, 242g, and 242h) while at least partially making contact with a fifth cam 241c_2a. The second shaft insertion hole 221_4d may be formed in the second arm extension 221_4c and may be disposed to pass through the x-axis and the -x-axis. A portion of the first rotary shaft 231 may be disposed in the second shaft insertion hole 221_4d. In this regard, the second shaft insertion hole 221_4d may have a diameter greater than or equal to the diameter of the first rotary shaft 231.

The third shaft connecting part 221_5 may include a third arm extension (or third arm extension portion) 221_5c, a fourth cam structure 221_5a, and a third shaft insertion hole 221_5d. The third extension 213_5a may be formed to be spaced apart from the second arm extension 221_4c by a predetermined distance in the x-axis direction and may have a tubular shape that extends from the first basic body 221_1 in the -y-axis direction and has the third shaft insertion hole 221_5d formed in a ring shape or a central portion. The gap between the first arm extension 221_3c and the fourth arm extension (or fourth arm extension portion) 221_4c may be equal to the gap between the second arm extension 221_4c and the third arm extension 221_5c. At least a portion of an upper surface of the third arm extension 221_5c may have the same height as the upper surface of the first basic body 221_1. The fourth cam structure 221_5a may be formed on one side of the third arm extension 221_5c and may be disposed to face in the -x-axis direction.

When the first arm part 221 rotates, the fourth cam structure 221_5a may perform a cam operation based on the elastic forces of the elastic members (e.g., 242e, 242f, 242g, and 242h) while at least partially making contact with a seventh cam 241d_2a. The third shaft insertion hole 221_5d may be formed in the third arm extension 221_5c and may be disposed to pass through the x-axis and the -x-axis. A portion of the first rotary shaft 231 may be disposed in the third shaft insertion hole 221_5d. In this regard, the third shaft insertion hole 221_5d may have a diameter greater than or equal to the diameter of the first rotary shaft 231.

The second arm part 222 may be fastened (or coupled) with the second rotary member 212 through the second fastening part 252 and may rotate in conjunction with the second rotary member 212 when a hinge operation is performed. According to an embodiment, the second arm part 222 may include the second basic body 221_1, the second connecting part 222_2, a fourth shaft connecting part 222_3, a fifth shaft connecting part 222_4, and a sixth shaft connecting part 222_5.

The second basic body 222_1 may have a shape that is the same as or similar to the shape of the first basic body 221_1 of the first arm part 221 described above. For example, the second connecting part 222_2 may be disposed on one side of the second basic body 222_1. The second connecting part 222_2 may include a hole that is open in the x-axis direction (or, the -x-axis direction) and into which at least a portion of the second fastening part 252 is inserted. In this regard, the hole of the second connecting part 222_2 may have a size similar to the diameter of the second fastening part 252.

The fourth shaft connecting part 222_3 may have a configuration that is the same as or similar to the configuration of the first shaft connecting part 221_3 of the first arm part 221 described above. For example, the fourth shaft connecting part 222_3 may include a stopper protrusion 222_3b that prevents (or limits) rotation of the second arm part 222 through a specified angle or more by making contact with a second stopper structure 243 a_31 of the center bracket 243a depending on a rotation state of the second arm part 222, a fifth cam structure 222_3a corresponding to the first cam structure 221_3a, and a shaft insertion hole that passes through the x-axis and the -x-axis and into which a portion of a second rotary shaft 232 is inserted. The fifth cam structure 222_3a may have ridges and valleys disposed to face in the x-axis direction, may face a second cam 241a_2b of the first cam member 241a, and may perform a cam operation based on the elastic forces of the elastic members (e.g., 242a, 242b, 242c, and 242d) in response to rotation of the second arm part 222.

The fifth shaft connecting part 222_4 may have a configuration that is the same as or similar to the configuration of the second shaft connecting part 221_4 of the first arm part 221 described above. For example, the fifth shaft connecting part 222_4 may include a sixth cam structure 222_4a corresponding to the second cam structure 221_4a of the first arm part 221, a seventh cam structure 222_4b corresponding to the third cam structure 221_4b of the first arm part 221, and a shaft insertion hole that passes through the x-axis and the - x-axis and into which a portion of the second rotary shaft 232 is inserted. The sixth cam structure 222_4a may have ridges and valleys disposed to face in the -x-axis direction, may face a fourth cam 241b_2b of the second cam member 241b, and may perform a cam operation based on the elastic forces of the elastic members (e.g., 242a, 242b, 242c, and 242d) in response to rotation of the second arm part 222. The seventh cam structure 222_4b may have ridges and valleys disposed to face in the x-axis direction, may face a sixth cam 241c_2b of the third cam member 241c, and may perform a cam operation based on the elastic forces of the elastic members (e.g., 242e, 242f, 242g, and 242h) in response to rotation of the second arm part 222.

The sixth shaft connecting part 222_5 may have a configuration that is the same as or similar to the configuration of the third shaft connecting part 221_5 of the first arm part 221 described above. For example, the sixth shaft connecting part 222_5 may include an eighth cam structure 222_5a corresponding to the seventh cam structure 222_4b and a shaft insertion hole that passes through the x-axis and the -x-axis and into which a portion of the second rotary shaft 232 is inserted. The seventh cam structure 222_4b may have ridges and valleys disposed to face in the -x-axis direction, may face an eighth cam 241d_2b of the fourth cam member 241d, and may perform a cam operation based on the elastic forces of the elastic members (e.g., 242e, 242f, 242g, and 242h) in response to rotation of the second arm part 222.

The first rotary shaft 231 may include a first pillar portion 231_1, the first shaft gear 231_2, a first shaft mounting portion 231_3, and a first ring mounting groove 231_4. The first rotary shaft 231 may rotate about the first axis 11 in a predetermined angle range (e.g., an angle range of 0 degrees to 100 degrees or an angle range of 0 degrees to **-100** degrees) depending on rotation of the first arm part 221. According to various embodiments, an end of the first pillar portion 231_1 facing in the -x-axis direction may be connected to the first shaft gear 231_2, and an end of the first shaft gear 231_2 facing in the -x-axis direction may be connected to the first shaft mounting portion 231_3 fastened (or coupled) to one side (e.g., the first mounting recess 213_3a) of the fixed bracket 213. The first ring mounting groove 231_4 to which a fixing clip (e.g., 291_1) is fastened (or coupled) may be formed at an end of the first pillar portion 231_1 that faces in the x-axis direction.

The first pillar portion 231_1 may have a rod shape longer in the y-axis direction than in the x-axis direction. At least a portion of the z-axis cross-section (e.g., the cross-section cut in the direction from the z-axis to the -z-axis) of the first pillar portion 231_1 may include a curve, and the remaining portion may include a straight line. For example, the first pillar portion 231_1 may be formed such that cross-sections (e.g., cross-sections cut in the direction from the z-axis to the -z-axis) of at least a portion of one surface in the z-axis direction and at least a portion of one surface in the -z-axis direction have a straight shape and at least a portion of one surface in the y-axis direction and at least a portion of one surface in the -y-axis direction have a curved shape. Accordingly, at least part of an upper portion of the first pillar portion 231_1 in the z-axis direction or the -z-axis direction may form a flat surface, and at least a portion of a side surface of the first pillar portion 231_1 in the y-axis direction or the -y-axis direction may form a curved surface. The z-axis cross-section of the first pillar portion 231_1 at least partially including a straight section may correspond to the z-axis cross-sectional shape of the shaft insertion holes (e.g., 221_3d, 221_4d, and 221_5d) formed in the first arm part 221. Accordingly, while the first arm part 221 rotates, the first pillar portion 231_1 may rotate depending on the rotation of the first arm part 221. The total length of the first pillar portion 231_1 may vary depending on components mounted on the first rotary shaft 231. For example, one side of the center bracket 243a, the first shaft connecting part 221_3, the first cam 241a_2a, the first elastic member 242a, the second cam structure 221_4a, the second shaft connecting part 221_4, the third cam structure 221_4b, the fifth elastic member 242e, the fourth cam structure 221_5a, the third shaft connecting part 221_5, one side of the shaft bracket 243b, and the fixing clip (e.g., 291_1) may be coupled to the first pillar portion 231_1.

According to various embodiments, the first shaft gear 231_2 may be formed at the end of the first pillar portion 231_1 that faces in the -x-axis direction. The size or diameter of a cross-section of one side of the first shaft gear 231_2 (e.g., the size or diameter of a cross-section in the z-axis or -z-axis direction) may be greater than the size or diameter of the z-axis cross-section of the first pillar portion 231_1 (e.g., the size or diameter of the cross-section cut in the direction from the z-axis to the -z-axis). Alternatively, the perimeter of the first shaft gear 231_2 may be greater than the perimeter of the first pillar portion 231_1, and a gear may be formed on an outer circumferential surface. The first shaft gear 231_2 may be, for example, a first shaft gear engaged (or coupled) with the helical gear 233. According to an embodiment, the first shaft gear 231_2 may include gear teeth in a diagonal direction from the -y-axis to the z-axis. The gear teeth in the diagonal direction may be formed, for example, at an angle of 45 degrees.

According to various embodiments, the first shaft mounting portion 231_3 may be connected to a central portion of the first shaft gear 231_2 and may extend in the -x-axis direction by a predetermined length. For example, the first shaft mounting portion 231_3 may have a length greater than the depth of the first mounting recess 213_3a formed in the fixed bracket 213. The z-axis cross-section of the first shaft mounting portion 231_3 may have a size smaller than the diameter (or, the z-axis cross-section) of the first mounting recess 213_3a. The z-axis cross-section of the first shaft mounting portion 231_3 may be formed in a circular shape.

According to various embodiments, the first ring mounting groove 23 1_4 may be formed at the end of the pillar portion 232_1 that faces in the x-axis direction. For example, the first ring mounting groove 231_4 may be formed in a position spaced apart by a predetermined gap in the -x-axis direction from the end of the first pillar portion 231_1 that faces in the x-axis direction and may have a smaller height than a portion around the first ring mounting groove 231_4. The first ring mounting groove 231_4 may be formed on the entire circumference of the first pillar portion 231_1. Accordingly, the first ring mounting groove 232_4 may be provided in an engraved strap shape on the first pillar portion 231_1. For example, the fixing clip (e.g., 291_2) may be inserted into the first ring mounting groove 232_4.

The second rotary shaft 232 may include a second pillar portion 232_1, the second shaft gear 232_2, a second shaft mounting portion 232_3, and a second ring mounting groove 232_4. The second rotary shaft 232 may rotate about the second axis 12 in a predetermined angle range (e.g., an angle range of 0 degrees to 100 degrees or an angle range of 0 degrees to -100 degrees) depending on rotation of the second arm part 222. According to various embodiments, an end of the second pillar portion 232_1 facing in the -x-axis direction may be connected to the second shaft gear 232_2, and an end of the second shaft gear 232_2 facing in the -x-axis direction may be connected to the second shaft mounting portion 232_3 fastened to one side (e.g., the second mounting recess 213_3b) of the fixed bracket 213. The second ring mounting groove 232_4 to which a fixing clip (e.g., 291_2) is fastened may be formed at an end of the second pillar portion 232_1 that faces in the x-axis direction.

The second pillar portion 232_1 may have the same size and shape as the first pillar portion 231_1 described above. For example, at least a portion of a z-axis cross-section of one side of the second pillar portion 232_1 may include a curved section, and the remaining portion may include a straight line. The total length of the second pillar portion 232_1 may vary depending on components mounted on the second rotary shaft 232. For example, the opposite side of the center bracket 243a, the fourth shaft connecting part 222_3, the second cam 241a_2b of the first cam member 241a, the fourth elastic member 242d, the fourth cam 241b_2b of the second cam member 241b, the fifth shaft connecting part 222_4, the sixth cam 241c_2b of the third cam member 241c, the eighth elastic member 242h, the eighth cam 241d_2b of the fourth cam member 241d, the sixth shaft connecting part 222_5, the opposite side of the shaft bracket 243b, and the fixing clip (e.g., 291_2) may be mounted on the second pillar portion 232_1. The second pillar portion 232_1 may have a length that corresponds to the widths of the components or is greater than the widths of the components.

The second shaft gear 232_2 may be formed in a shape identical or similar to that of the first shaft gear 231_2 described above. For example, the second shaft gear 232_2 may include gear teeth inclined in a diagonal direction from the -y-axis to the z-axis (e.g., an oblique direction among directions from the rear surface to the front surface of the display 160). The direction and shape of the gear teeth of the second shaft gear 232_2 may be the same as the direction and shape of the gear teeth of the first shaft gear 231_2.

The second ring mounting groove 232_3 may have a form identical or similar to that of the first ring mounting groove 231_4. For example, the second ring mounting groove 232_4 may be formed at an edge of the second pillar portion 232_1 that faces in the x-axis direction and may be formed in a lower position than a portion around the second ring mounting groove 232_4 to have an engraved strap shape. The fixing clip (e.g., 291_2) may be inserted into the second ring mounting groove 232_4.

The second shaft mounting portion 232_3 may have a form identical or similar to that of the first shaft mounting portion 231_3. The second shaft mounting portion 232_3 may be seated in the second mounting recess 213_3b formed in the fixed bracket 213.

The center bracket 243a may include a center body 243a_1, a first bracket wing part 243a_2, a second bracket wing part 243a_3, and a gear mounting part 243a_4.

According to various embodiments, the center body 243a_1 may include U-shaped vertical sidewalls that are open in the x-axis direction and a horizontal sidewall disposed in the form of an x-y plane inside the sidewalls. A center hole 243a_1a used to fix the center bracket 243a to the hinge housing 150 may be formed in the horizontal sidewall of the center body 243a_1. An end of the center body 243a_1 that faces in the x-axis direction may be disposed to be brought into contact with one side of the first cam member 241a. The vertical sidewalls of the center body 243a_1 may be disposed side by side with the first shaft connecting part 221_3 of the first arm part 221 and the fourth shaft connecting part 222_3 of the second arm part 222.

According to various embodiments, the first bracket wing part 243a_2 may be formed to protrude in the y-axis direction from a central region of the center body 243a_1. The first bracket wing part 243a_2 may include a first stopper structure 243a_21 and a first bracket hole 243a_22. The first stopper structure 243a_21 may be formed to surround only a portion of the periphery of the first bracket hole 243a_22 and may protrude in the x-axis direction. The first stopper structure 243a_21 may make contact with the first stopper protrusion 221_3b, which is formed on the first arm part 221, at a predetermined angle. The first bracket hole 243a_22 may be formed through the first bracket wing part 243a_2 while crossing the -x-axis and the x-axis. The size of the first bracket hole 243a_22 may be the same as or similar to the thickness of the first rotary shaft 231. Alternatively, the shape (e.g., a circular shape) of the first bracket hole 243a_22 may differ from the shape of the first rotary shaft 231 (e.g., a closed curve including a curve and a straight line), and the first bracket hole 243a_22 may have a larger diameter than the first rotary shaft 231. The first rotary shaft 231 may be inserted into the first bracket hole 243a_22, and the first rotary shaft 231 may rotate in the first bracket hole 243 a_22.

The second bracket wing part 243a_3 may be formed to protrude in the -y-axis direction from a central region of the center body 243a_1. The second bracket wing part 243a_3 may include the second stopper structure 243 a_31 and a second bracket hole 243a_32. The second stopper structure 243a_31 may have the same shape and size as the first stopper structure 243a_21 described above and may be disposed in a structure symmetrical to the first stopper structure 243a_21 with respect to the x-axis. The second stopper structure 243a_31 may make contact with the second stopper protrusion 222_3b, which is formed on the second arm part 222, at a predetermined angle to prevent (or limit) rotation of the second arm part 222 through a specified angle or more. The second bracket hole 243a_32 may be formed through the second bracket wing part 243a_3 while crossing the -x-axis and the x-axis. The size and shape of the second bracket hole 243a_32 may be similar to the size and shape of the first bracket hole 243a_22. For example, the size of the second bracket hole 243a_32 may be the same as or similar to the thickness of the second rotary shaft 232. Alternatively, the shape (e.g., a circular shape) of the second bracket hole 243a_22 may differ from the shape of the second rotary shaft 232 (e.g., a closed curve including a curve and a straight line), and the second bracket hole 243a_32 may have a larger diameter than the second rotary shaft 232. The second rotary shaft 232 may be inserted into the second bracket hole 243a_32, and the second rotary shaft 232 may rotate in the second bracket hole 243a_32.

The gear mounting part 243a_4 may be formed to protrude in the -x-axis direction from one side of the center body 243a_1. A portion of the gear mounting part 243a_4 that faces in the -x-axis direction may have a concave shape when viewed in the z-axis direction. The gear mounting part 243a_4 may be inserted into a recess formed on a central portion of the helical gear 233 and may prevent (or limit) separation of the helical gear 233 or movement of the helical gear 233 exceeding a predetermined magnitude.

The detent structure 240 may include the cam members 241a, 241b, 241c, and 241d, the cam structures 221_3a, 221_4a, 221_4b, 221_5a, 222_3a, 222_4a, 222_4b, and 222_5a, and the plurality of elastic members 242a, 242b, 242c, 242d, 242e, 242f, 242g, and 242h that provide elastic forces to the cam members 241a, 241b, 241c, and 241d and the cam structures 221_3a, 221_4a, 221_4b, 221_5a, 222_3a, 222_4a, 222_4b, and 222_5a. Additionally or alternatively, the detent structure 240 may further include the shaft bracket 243b that supports one side of the fourth cam member 241d among the cam members. The above-described detent structure 240 may improve wear performance by friction of the cam structures 221_3a, 221_4a, 221_4b, 221_5a, 222_3a, 222_4a, 222_4b, and 222_5a and the cam members 241a, 241b, 241c, and 241d while providing a relatively high friction force using a plurality of cam operation units or parts constituted by the plurality of cam structures 221_3a, 221_4a, 221_4b, 221_5a, 222_3a, 222_4a, 222_4b, and 222_5a and the cam members 241a, 241b, 241c, and 241d. Additionally, the detent structure 240 may improve space utilization while increasing elasticity by disposing the additional elastic members (e.g., 242b, 242c, 242f, and 242g) between the cam members 241a, 241b, 241c, and 241d.

The first cam member 241a may include a first cam body 241a_1, the first cam 241a_2a, the second cam 241a_2b, a first cam hole 241a_4a, a second cam hole 241a_4b, a first elastic-body mounting protrusion 241a_3a, and a second elastic-body mounting protrusion 241a_3b. The first cam body 241a_1 may have a plate shape formed to be longer in the y-axis or -y-axis direction than in the x-axis direction. The first cam 241a_2a may be formed at the y-axis edge of the first cam body 241a_1, and the second cam 241a_2b may be formed at the -y-axis edge of the first cam body 241a_1. The first elastic-body mounting protrusion 241a_3a and the second elastic-body mounting protrusion 241a_3b spaced apart from each other by a predetermined gap may be disposed on the surface of the first cam body 241a_1 that faces in the x-axis direction. The first elastic-body mounting protrusion 241a_3a and the second elastic-body mounting protrusion 241a_3b may protrude by a predetermined length in the x-axis direction from the surface of the first cam body 241a_1 that faces in the x-axis direction. One side of the second elastic member 242b may be mounted on the first elastic-body mounting protrusion 241a_3a, and one side of the third elastic member 242c may be mounted on the second elastic-body mounting protrusion 241a_3b. In this regard, the z-axis cross-section of the first elastic-body mounting protrusion 241a_3a may be formed to be smaller than an opening in a central portion of the second elastic member 242b, and the z-axis cross-section of the second elastic-body mounting protrusion 241a_3b may be formed to be smaller than an opening in a central portion of the third elastic member 242c. The first cam 241a_2a and the second cam 241a_2b may be located above the first elastic-body mounting protrusion 241a_3a and the second elastic-body mounting protrusion 241a_3b in the z-axis direction. Ridges and valleys of the first cam 241a_2a and ridges and valleys of the second cam 241a_2b may be disposed to face in the -x-axis direction. The first cam hole 241a_4a may be located in the central portion of the first cam 241a_2a and may be formed to cross the x-axis and the -x-axis. A portion of the first rotary shaft 231 may be disposed in the first cam hole 241a_4a. The second cam hole 241a_4b may be located in the central portion of the second cam 241a_2b and may be formed to cross the x-axis and the -x-axis. A portion of the second rotary shaft 232 may be disposed in the second cam hole 241a_4b.

The second cam member 241b may include a second cam body 241b_1, the third cam 241b_2a, the fourth cam 241b_2b, a third cam hole 241b_4a, a fourth cam hole 241b_4b, a third elastic-body mounting protrusion 241b_3a, and a fourth elastic-body mounting protrusion 241b_3b. The second cam member 241b may have the same shape and size as the first cam member 241a. According to an embodiment, the second cam member 241b may be disposed in a structure symmetrical to the first cam member 241a with respect to the y-axis. For example, ridges and valleys of the third cam 241b_2a and ridges and valleys of the fourth cam 241b_2b may be disposed to face in the -x-axis direction. The third cam hole 24 1b_4a may be formed in the central portion of the third cam 241b_2a, and a portion of the first rotary shaft 231 may be inserted into the third cam hole 241b_4a. The fourth cam hole 241b_4b may be formed in the central portion of the fourth cam 241b_2b, and a portion of the second rotary shaft 232 may be inserted into the fourth cam hole 241b_4b. The third elastic-body mounting protrusion 241b_3a and the fourth elastic-body mounting protrusion 241b_3b may protrude to face in the -x-axis direction. An opening on an opposite side of the second elastic member 242b may be mounted on the third elastic-body mounting protrusion 241b_3a, and an opening on an opposite side of the third elastic member 242c may be mounted on the fourth elastic-body mounting protrusion 241b_3b.

The third cam member 241c may include a third cam body 241c_1, the fifth cam 241c_2a, the sixth cam 241c_2b, a fifth cam hole 241c_4a, a sixth cam hole 241c_4b, a fifth elastic-body mounting protrusion 241c_3a, and a sixth elastic-body mounting protrusion 241c_3b. The third cam member 241c may have the same shape and size as the first cam member 241a or the second cam member 241b. According to an embodiment, the third cam member 241c may have the same arrangement state as the first cam member 241a, and the positions where the third cam member 241c and the first cam member 241a are disposed may differ from each other. For example, ridges and valleys of the fifth cam 241c_2a and ridges and valleys of the sixth cam 241c_2b may be disposed to face in the -x-axis direction. The fifth cam hole 241c_4a may be formed in the central portion of the fifth cam 241c_2a, and a portion of the first rotary shaft 231 may be inserted into the fifth cam hole 241c_4a. The sixth cam hole 241c_4b may be formed in the central portion of the sixth cam 241c_2b, and a portion of the second rotary shaft 232 may be inserted into the sixth cam hole 241c_4b. The fifth elastic-body mounting protrusion 241c_3a and the sixth elastic-body mounting protrusion 241c_3b may protrude to face in the -x-axis direction. An opening on one side of the sixth elastic member 242f may be mounted on the fifth elastic-body mounting protrusion 241c_3a, and an opening on one side of the seventh elastic member 242g may be mounted on the sixth elastic-body mounting protrusion 241c_3b.

The fourth cam member 241d may include a fourth cam body 241d_1, the seventh cam 241d_2a, the eighth cam 241d_2b, a seventh cam hole 241d_4a, an eighth cam hole 241d_4b, a seventh elastic-body mounting protrusion 241d_3a, and an eighth elastic-body mounting protrusion 241d_3b. The fourth cam member 241d may have the same shape and size as the first cam member 241a, the second cam member 241b, or the third cam member 241c. According to an embodiment, the fourth cam member 241d may have the same arrangement state as the second cam member 241b, and the positions where the fourth cam member 241d and the second cam member 241b are disposed may differ from each other. For example, ridges and valleys of the seventh cam 241d_2a and ridges and valleys of the eighth cam 241d_2b may be disposed to face in the x-axis direction. The seventh cam hole 241d_4a may be formed in the central portion of the seventh cam 241d_2a, and a portion of the first rotary shaft 231 may be inserted into the seventh cam hole 241d_4a. The eighth cam hole 241d_4b may be formed in the central portion of the eighth cam 241d_2b, and a portion of the second rotary shaft 232 may be inserted into the eighth cam hole 241d_4b. The seventh elastic-body mounting protrusion 241d_3a and the eighth elastic-body mounting protrusion 241d_3b may protrude to face in the - x-axis direction. An opening on an opposite side of the sixth elastic member 242f may be mounted on the seventh elastic-body mounting protrusion 241d_3a, and an opening on an opposite side of the seventh elastic member 242g may be mounted on the eighth elastic-body mounting protrusion 241d_3b.

According to various embodiments, the shaft bracket 243b may include a shaft body 243b_1 fixedly mounted on a boss provided on the hinge housing 150, a shaft hole 243b_1a formed in the center of the shaft body 243b_1 to cross the z-axis and the -z-axis, a first shaft wing 243b_2 extending from the shaft body 243b_1 in the y-axis direction, and a second shaft wing 243b_3 extending from the shaft body 243b_1 in the -y-axis direction. As a coupling member (e.g., a screw) is inserted into the shaft hole 243b_1a and coupled to the boss provided on the hinge housing 150, the shaft bracket 243b may be fixed to the hinge housing 150. A hole crossing the -x-axis and the x-axis may be formed in the first shaft wing 243b_2, and an end of the first rotary shaft may be disposed through the hole formed in the first shaft wing 243b_2. A hole crossing the -x-axis and the x-axis may be formed in the second shaft wing 243b_3, and an end of the second rotary shaft may be disposed through the hole formed in the second shaft wing 243b_3. While the above-described shaft bracket 243b is coupled to the hinge housing 150, the first shaft wing 243b_2 may be coupled with one side of the first arm part 221 (e.g., one side of the third shaft connecting part 221_5 of the first arm part 221) through the first rotary shaft 231, and the second shaft wing 243b_3 may be coupled with one side of the second arm part 222 (e.g., one side of the sixth shaft connecting part 222_5 of the second arm part 222) through the second rotary shaft 232. The shaft bracket 243b may support the first arm part 221 and the second arm part 222 and may prevent (or limit) movement of the first rotary shaft 231 and the second rotary shaft 232.

The fixing clips 291_1 and 291_2 may include the first fixing clip 291_1 inserted into the first ring mounting groove 231_4 provided at the end of the first rotary shaft 231 disposed through the hole of the first shaft wing 243b_2 and the second fixing clip 291_2 inserted into the second ring mounting groove 232_4 provided at the end of the second rotary shaft 232 disposed through the hole of the second shaft wing 243b_3.

As described above, the hinge structures 200a and 200b according the embodiment may include the rotary members 211 and 212 coupled with the hinge housing 150 and the housings 110 and 120 and involved in a folding or unfolding operation of the display 160 located above, the detent structure 240 connected to the rotary members 211 and 212, the gear structure 230 (e.g., the first shaft gear 231_2 formed on the first rotary shaft 231 and the second shaft gear 232_2 formed on the second rotary shaft 232) that supports simultaneous rotation operations of the first housing 110 and the second housing 120, and the helical gear 233 engaged (or coupled) with the first shaft gear 231_2 and the second shaft gear 232_2.

The above-described hinge structures 200a and 200b may have an interlocking structure in which the helical gear 233 that has a gear pattern (or, a helical pattern) disposed in the x-y plane direction and rotates about the z-axis is connected to the first shaft gear 231_2 and the second shaft gear 232_2 that have a gear pattern (e.g., a helical pattern) disposed in the y-z plane direction and rotate about the x-axis and the first arm part 221 and the second arm part 222 operate in conjunction with each other. The above-described hinge structures 200a and 200b of the electronic device may reduce the thickness of the electronic device by applying the helical gear 233 having a minimized height in the z-axis direction to the interlocking structure. Furthermore, by reducing the height in the z-axis direction by employing the helical gear 233, the above-described hinge structures 200a and 200b of the electronic device may prevent contact of the hinge structures 200a and 200b with one side (e.g., the central portion) of the display 160, thereby preventing damage to the display 160. In addition, by additionally disposing the plurality of elastic members between the cam members, the hinge structures 200a and 200b of the electronic device may provide a friction force due to high elasticity, thereby easily maintaining a mounting state (e.g., a free-stop structure) at a specific angle and reducing wear of the cam members.

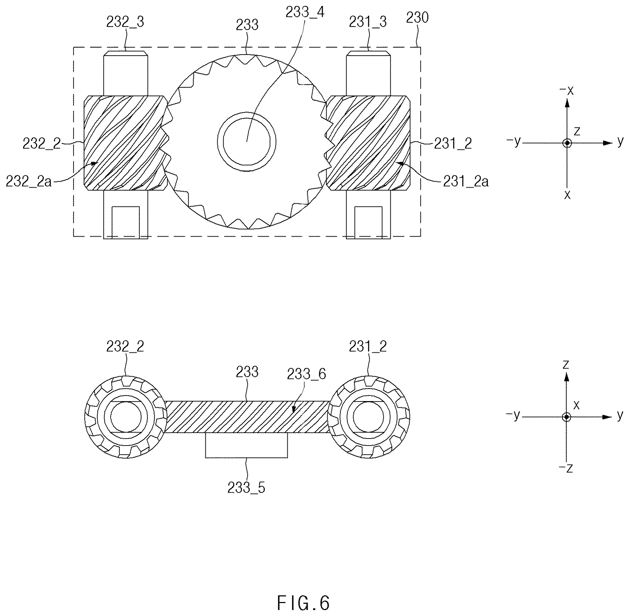

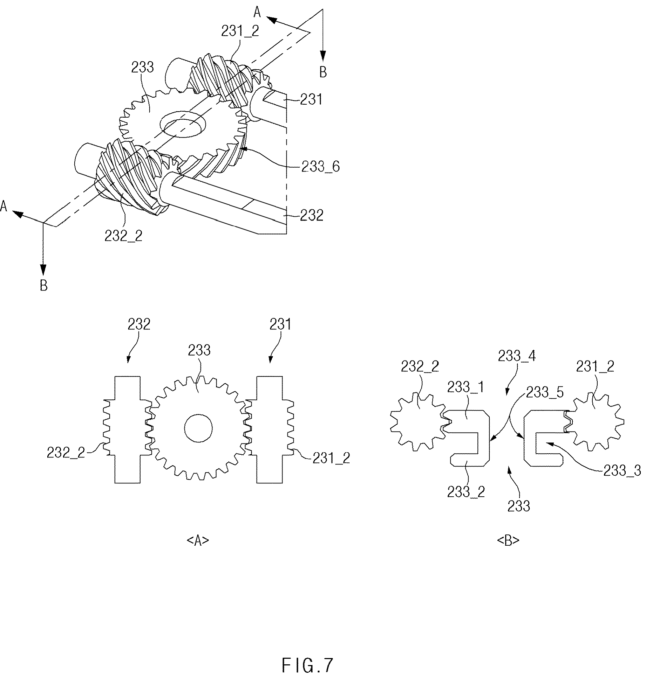

FIG. 6 is a view illustrating an example of the gear structure according to an embodiment, and FIG. 7 is a view illustrating an example of various cut sections of the gear structure according to an embodiment.

Referring to FIGS. 6 and 7, the gear structure 230 according to an embodiment may include the first shaft gear 231_2 formed on the first rotary shaft 231, the second shaft gear 232_2 formed on the second rotary shaft 232, and the helical gear 233. The first shaft gear 231_2 may be engaged (or coupled) with the helical gear 233 in the y-axis direction with respect to the helical gear 233, and the second shaft gear 232_2 may be engaged (or coupled) with the helical gear 233 in the -y-axis direction with respect to the helical gear 233. The helical gear 233 may include a first gear body 233_1, a gear hole 233_4 formed in the central portion of the first gear body 233_1, a helical gear pattern 233_6 formed on the side surface (e.g., the x-y plane) of the first gear body 233_1, a pillar portion 233_5 supporting the first gear body 233_1, and a second gear body 233_2 formed at the lower end of the pillar portion 233_5 and formed parallel to the first gear body 233_1. The first gear body 233_1, when viewed in the z-axis direction, may have a circular plate shape having the gear hole 233_4 formed in the central portion thereof. The pillar portion 233_5 may have a predetermined length in the z-axis direction and may have the gear hole 233_4 formed in the central portion thereof. The second gear body 233_2 may have a circular plate shape having the gear hole 233_4 formed in the central portion thereof. The second gear body 233_2 may have a smaller area than the first gear body 233_1. The z-axis cross-section of the helical gear 233 described above may have a c-shape. At least a portion of the first extension 213_4a and at least a portion of the second extension 213_4b of the fixed bracket 213 may be inserted into a strap-shaped groove 233_3 that is formed by the first gear body 233_1, the pillar portion 233_5, and the second gear body 233_2 of the helical gear 233. According to various embodiments, at least a portion of the gear mounting part 243a_4 may be inserted into the strap-shaped groove 233_3. The strap-shaped groove 233_3 may perform a rotation operation while being fixed by the first extension 213_4a, the second extension 213 4b, and the gear mounting part 243a_4 without being separated in the z-axis direction.

The helical gear pattern 233_6 may include ridges and valleys that face in a diagonal direction (e.g., a 45 degree direction) between the y-axis and the z-axis. The first shaft gear 231_2 may include a first gear pattern 231_2a (or, a first auxiliary helical gear pattern) including ridges and valleys that face in a diagonal direction (e.g., a 45 degree direction) between the -x-axis and the y-axis. The second shaft gear 232_2 may include a second gear pattern 232_2a (or, a second auxiliary helical gear pattern) including ridges and valleys that face in a diagonal direction (e.g., a 45 degree direction) between the -x-axis and the y-axis. The first gear pattern 231_2a and the second gear pattern 232_2a may be formed in the same direction. The helical gear pattern 233_6 may be vertically coupled with the first gear pattern 231_2a and the second gear pattern 232_2a.

In the above-described gear structure 230, the first shaft gear 231_2 coupled with the first arm part 221 may rotate about the -x-axis in the counterclockwise direction when the first arm part 221 rotates in the first direction (e.g., when the first housing 110 rotates from the unfolded state to the folded state). The helical gear 233 engaged (or coupled) with the first shaft gear 231_2 may rotate in the clockwise direction when the first shaft gear 231_2 rotates in the counterclockwise direction. The second shaft gear 232_2 engaged (or coupled) with the helical gear 233 may rotate in the clockwise direction when the helical gear 233 rotates in the clockwise direction. As described above, the first shaft gear 23 1_2 and the second shaft gear 232_2 may rotate in opposite directions, for example, in directions in which the first shaft gear 231_2 and the second shaft gear 232_2 face toward each other, in directions toward the helical gear 233, or in a direction from the z-axis to the -z-axis.

According to various embodiments, in the above-described gear structure 230, the first shaft gear 231_2 coupled with the first arm part 221 may rotate about the -x-axis in the clockwise direction when the first arm part 221 rotates in a second direction (e.g., when the first housing 110 rotates from the folded state to the unfolded state). The helical gear 233 engaged (or coupled) with the first shaft gear 231_2 may rotate in the counterclockwise direction when the first shaft gear 231_2 rotates in the clockwise direction. The second shaft gear 232_2 engaged (or coupled) with the helical gear 233 may rotate in the counterclockwise direction when the helical gear 233 rotates in the counterclockwise direction. As described above, the first shaft gear 231_2 and the second shaft gear 232_2 may rotate in opposite directions, for example, in directions in which the first shaft gear 231_2 and the second shaft gear 232_2 face away from each other, in directions away from the helical gear 233, or in a direction from the -z-axis to the z-axis.

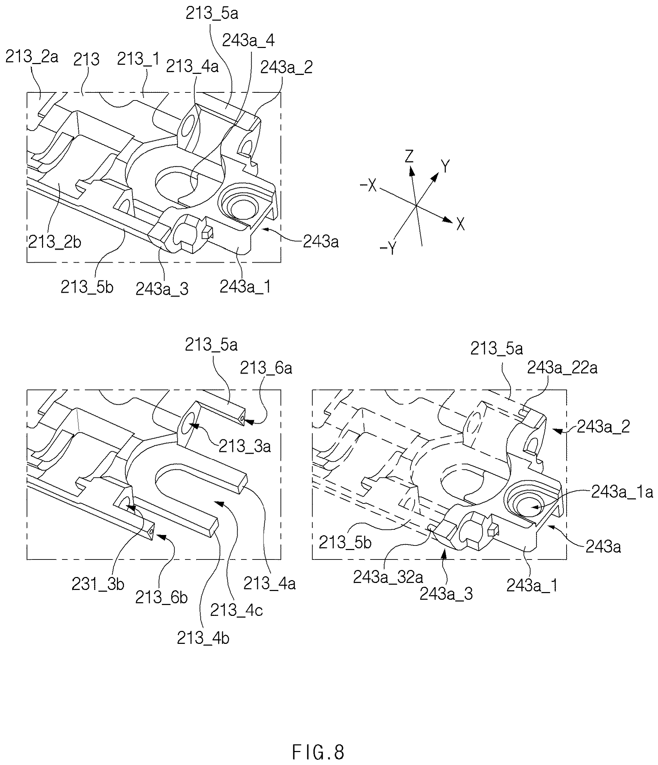

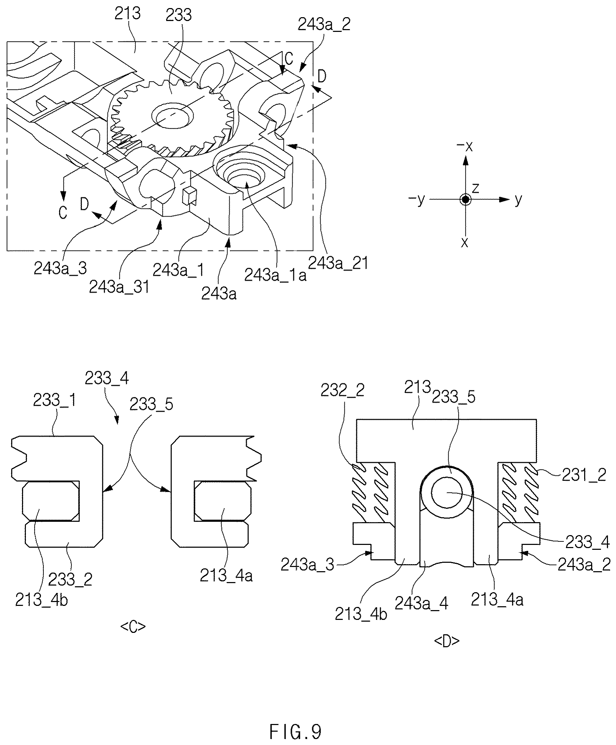

FIG. 8 is a view illustrating an example of the fixed bracket and the center bracket according to an embodiment, and FIG. 9 is a view illustrating an example of a coupled state of the fixed bracket, the center bracket, and the helical gear according to an embodiment.

Referring to FIGS. 8 and 9, as described above with reference to FIG. 5, the fixed bracket 213 may be fixedly disposed in a predetermined position inside the hinge housing 150 and may include the first rail hole 213_2a into which the first rotary member 211 is inserted to rotate within a specified angle and the second rail hole 213_2b into which the second rotary member 212 is inserted to rotate within a specified angle. In a region adjacent to the first rail hole 213_2a of the fixed bracket 213, a predetermined space where at least a part (e.g., the helical gear 233, the first shaft gear 231_2, and the second shaft gear 232_2) of the gear structure 230 is inserted and mounted may be provided, and a structure for fixing at least a part of the gear structure 230 may be disposed. For example, the fixed bracket 213 may include the first extension 213_4a extending in the x-axis direction from the bottom surface facing in the -z-axis direction among regions adjacent to the second rail hole 213_2b and the second extension 213_4b extending parallel to the first extension 213_4a in the x-axis direction from the bottom surface facing in the -z-axis direction among the regions adjacent to the second rail hole 213_2b. The first extension 213_4a and the second extension 213_4b may be spaced apart from each other by a predetermined distance in the y-axis direction and may be disposed side by side on the x-y plane. The edges of the first extension 213_4a and the second extension 213_4b that face in the -x-axis direction may be connected to each other to entirely form a U-shape when viewed in the z-axis direction. At least portions of the first extension 213_4a and the second extension 213-4b may be inserted into the strap-shaped groove 233_3 formed on the helical gear 233, and the pillar portion 233_5 of the helical gear 233 may be disposed in at least a portion of the opening 213_4c between the first extension 213_4a and the second extension 213_4b. According to an embodiment, after the pillar portion 233_5 of the helical gear 233 is seated on one side of the opening 231_4c, the gear mounting part 243a_4 of the center bracket 243a may be disposed in the opening 213_4c to prevent (or limit) movement of the helical gear 233.

The fixed bracket 213 may include the third extension 213_5a extending in the x-axis direction from the upper surface facing in the z-axis direction among edge regions in the x-axis direction that are adjacent to the second rail hole 213_2b and the fourth extension 213_5b extending parallel to the third extension 213_5a in the x-axis direction from the upper surface facing in the z-axis direction among the edge regions in the x-axis direction that are adjacent to the second rail hole 213_2b. The third extension 213_5a and the fourth extension 213_5b may be spaced apart from each other by a predetermined distance in the y-axis direction and may be disposed side by side on the x-y plane. The gap between the third extension 213_5a and the fourth extension 213_5b may be greater than the gap between the first extension 213_4a and the second extension 213_4b. The third extension 213_5a may include a first insertion recess 213_6a engraved in the -x-axis direction at an end facing in the x-axis direction. A first bracket protrusion 243a_22a protruding in the -x-axis direction from one side (e.g., an end facing in the y-axis direction) of the first bracket wing part 243a_2 of the center bracket 243a may be inserted into the first insertion recess 213_6a. The fourth extension 213_5b may include a second insertion recess 213_6b engraved in the -x-axis direction at an end facing in the x-axis direction. A second bracket protrusion 243a_32 protruding in the -x-axis direction from one side (e.g., an end facing in the y-axis direction) of the second bracket wing part 243a_3 of the center bracket 243a may be inserted into the first insertion recess 213_6b.

The first mounting recess 213_3a engraved in the -x-axis direction may be formed in a surface that faces in the x-axis direction and to which the third extension 213_5a is adjacent, among the edge regions in the x-axis direction that are adjacent to the second rail hole 213_2b of the fixed bracket 213. The first shaft mounting portion 231_3 of the first rotary shaft 231 may be inserted into the first mounting recess 213_3a. The second mounting recess 213_3b engraved in the -x-axis direction and spaced apart from the first mounting recess 213_3a by a predetermined distance may be formed in a surface that faces in the x-axis direction and to which the fourth extension 213_5b is adjacent, among the edge regions in the x-axis direction that are adjacent to the second rail hole 213_2b of the fixed bracket 213. The second shaft mounting portion 232_3 of the second rotary shaft 232 may be inserted into the second mounting recess 213_3b. The gap between the first mounting recess 213_3a and the second mounting recess 213_3b may be smaller than the gap between the third extension 213_5a and the fourth extension 213_5b and may be greater than the gap between the first extension 213_4a and the second extension 213_4b.

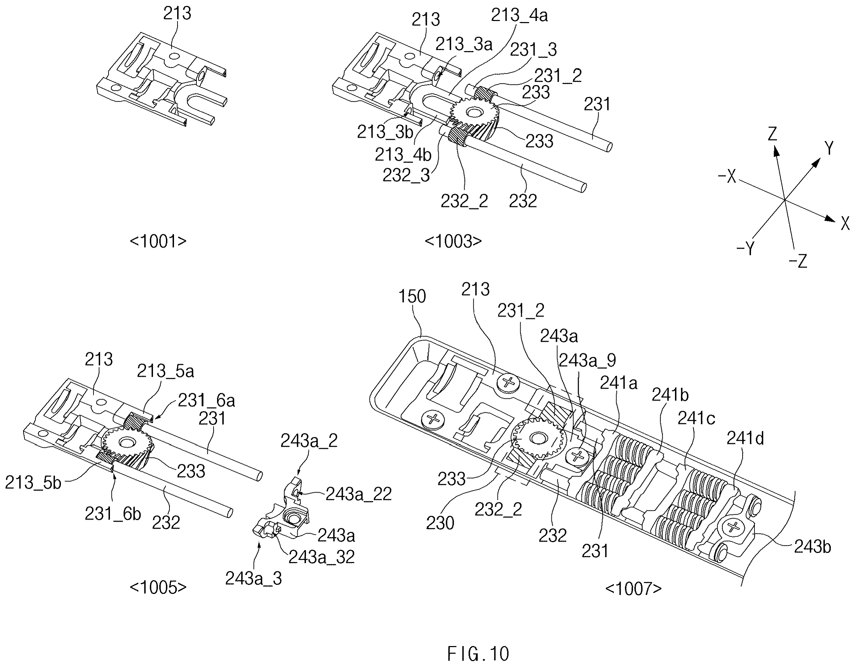

FIG. 10 is a view illustrating an example of a coupling of at least some components of the hinge structure according to an embodiment.

Referring to FIGS. 5, 8, and 10, the fixed bracket 213, to which the first rotary member 211 and the second rotary member 212 are fastened in the direction from the z-axis to the -z-axis and the gear structure 230 is fastened in the direction from the x-axis to the -x-axis, may be provided in step 1001.

In step 1003, the gear structure 230, in which the helical gear 233, the first shaft gear 231_2, and the second shaft gear 232_2 are coupled, may be inserted into one side of the fixed bracket 213. For example, the helical gear 233 may be seated between the first extension 213_4a and the second extension 213_4b and may be inserted up to the portion where the first extension 213_4a and the second extension 213_4b are connected. In the state in which the first shaft gear 231_2 formed on the first rotary shaft 231 is engaged (or coupled) with the helical gear 233, the first shaft mounting portion 231_3 of the first rotary shaft 231 may be inserted into the first mounting recess 213_3a, and in the state in which the second shaft gear 232_2 formed on the second rotary shaft 232 is engaged (or coupled) with the helical gear 233, the second shaft mounting portion 232_3 of the second rotary shaft 232 may be inserted into the second mounting recess 213_3b.

In step 1005, the center bracket 243a may be mounted on the first rotary shaft 231 and the second rotary shaft 232 and may move in the -x-axis direction to prevent (or limit) movement of the helical gear 233, the first shaft gear 23 1_2, and the second shaft gear 232_2. In this process, the first bracket wing part 243a_2 of the center bracket 243a may be mounted on the first rotary shaft 231, the second bracket wing part 243a_3 of the center bracket 243a may be mounted on the second rotary shaft 232, the first bracket protrusion 243a_22a of the first bracket wing part 243a_2 may be fastened (or coupled) to the first insertion recess 213_6a formed on the third extension 213_5a, and the second bracket protrusion 243a_32 of the second bracket wing part 243a_3 may be fastened (or coupled) to the second insertion recess 213_6b formed on the fourth extension 213_5b. A fastening member 243a_9 may be fastened (or coupled) to fix the center bracket 243a to the hinge housing 150.

In step 1007, the plurality of cam members 241a, 241b, 241c, and 241d, the plurality of elastic members 242a, 242b, 242c, 242d, 242e, 242f, 242g, and 242h, and the arm parts (not illustrated) may be alternately coupled to the first rotary shaft 231 and the second rotary shaft 232, and the shaft bracket 243b may be coupled to the x-axis ends of the first rotary shaft 231 and the second rotary shaft 232. In this state, the fixed bracket 213, the center bracket 243a, and the shaft bracket 243b may be coupled with bosses formed on the hinge housing 150, and fixing members (e.g., screws) may fasten the fixed bracket 213, the center bracket 243a, and the shaft bracket 243b to the hinge housing 150 to fix the fixed bracket 213, the center bracket 243a, and the shaft bracket 243b.

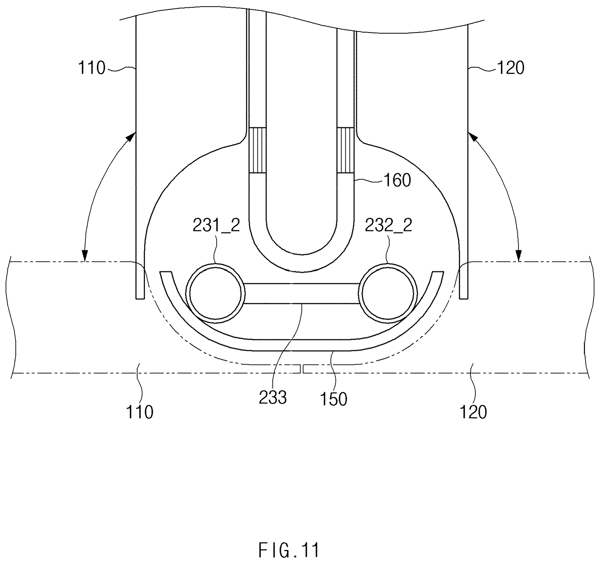

FIG. 11 is a view illustrating an example of a section of some components of the electronic device according to an embodiment.

Referring to FIG. 11, at least a part of the electronic device 100 may include the first housing 110, the second housing 120, the display 160, the hinge housing 150, the helical gear 233, the first shaft gear 231_2, and the second shaft gear 232_2. The first housing 110 and the second housing 120 may have a folded or unfolded state. When the first housing 110 and the second housing 120 are changed from the unfolded state to the folded state, the state in which the first housing 110 and the second housing 120 are disposed side by side in the y-axis direction may be changed to the state in which the first housing 110 and the second housing 120 are disposed parallel to each other in the z-axis direction. When the electronic device 100 is in the folded state, the display 160 may have a folded state, and a predetermined gap may be formed between the central portion 163 of the display 160 and the helical gear 233. Accordingly, when the electronic device 100 is in the folded state, even though external pressure (e.g., impact due to dropping) occurs, a collision between the display 160 and the helical gear 233 may be suppressed, and thus damage to the display 160 may be prevented.

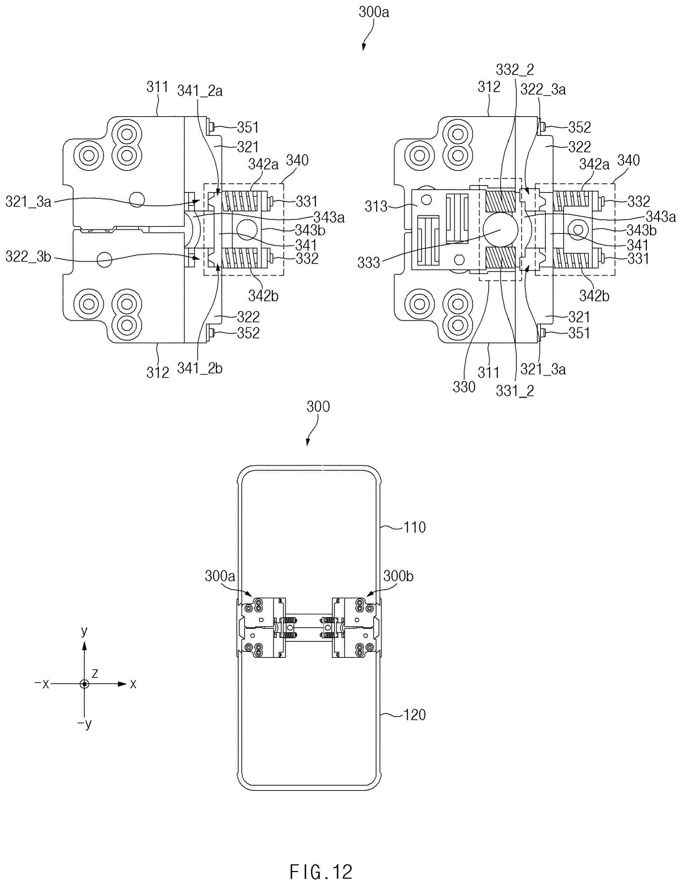

FIG. 12 is a view illustrating a hinge structure of an electronic device according to another embodiment.

Referring to FIG. 12, at least a part of the electronic device 300 may include a first housing 110, a second housing 120, a first hinge structure 300a, and a second hinge structure 300b. Additionally or alternatively, the electronic device 300 may further include a display (e.g., the display 160 of FIG. 1).

According to an embodiment, the hinge structure 300a may include, for example, a first rotary member 311 fastened with the first housing 110, a second rotary member 312 fastened with the second housing 120, a first arm part 321, a second arm part 322, a first fastening part 351, a second fastening part 352, a fixed bracket 313, a gear structure 330, a center bracket 343a, and a detent structure 340. In the above configuration, the first rotary member 311, the second rotary member 312, the first arm part 321, the second arm part 322, the fixed bracket 313, the center bracket 343a, and the gear structure 330 may be components that are the same as or similar to the first rotary member 211, the second rotary member 212, the first arm part 221, the second arm part 222, the first fastening part 251, the second fastening part 252, the fixed bracket 213, the center bracket 243a, and the gear structure 230 described above with reference to FIGS. 4 and 5. According to various embodiments, when compared with the first arm part 221 and the second arm part 222 described with reference to FIGS. 4 and 5, the first arm part 321 and the second arm part 322 may be provided in a form in which the length in the x-axis direction is reduced depending on a change of the detent structure 340. According to an embodiment, the first arm part 321 may include a first cam structure 321_3a, and the second arm part 322 may include a second cam structure 322_3a.

The detent structure 340 may include a portion of a first rotary shaft 331, a portion of a second rotary shaft 332, a cam member 341, a first elastic member 342a, a second elastic member 342b, and a shaft bracket 343b. The first rotary shaft 331 and the second rotary shaft 332 may be components that are the same as or similar to the first rotary shaft 231 and the second rotary shaft 232 described with reference to FIGS. 4 and 5, differing only in the length. The cam member 341 may include a first cam 341_2a coupled with the first cam structure 321_3a and a second cam 341_2b coupled with the second cam structure 322_3a.

As described above, the electronic device 300 according to the embodiment may be formed of a hinge structure including relatively few cams, cam structures, and elastic members, compared to the hinge structure described with reference to FIGS. 4 and 5.

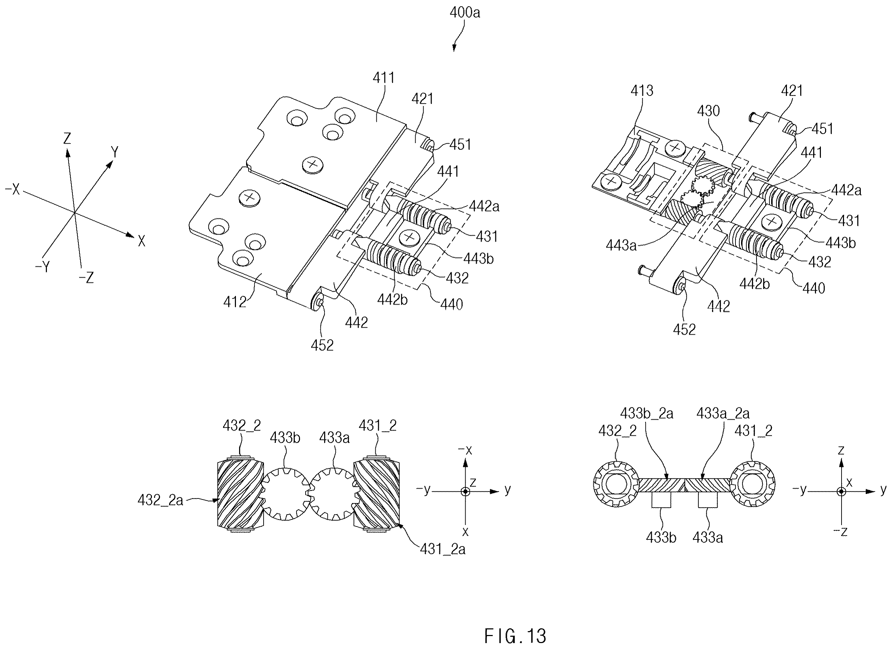

FIG. 13 is a view illustrating a hinge structure of an electronic device according to another embodiment.

Referring to FIG. 13, the hinge structure 400a of the electronic device according to an embodiment may include a first rotary member 411, a second rotary member 412, a first arm part 421, a second arm part 422, a first fastening part 451, a second fastening part 452, a fixed bracket 413, a gear structure 430, a center bracket 443a, and a detent structure 440. In the above configuration, the first rotary member 411, the second rotary member 412, the first arm part 421, the second arm part 422, the fixed bracket 413, and the center bracket 443a may be components that are the same as or similar to the first rotary member 211, the second rotary member 212, the first arm part 221, the second arm part 222, the first fastening part 251, the second fastening part 252, the fixed bracket 213, and the center bracket 243a described above with reference to FIGS. 4 and 5. According to various embodiments, when compared to the fixed bracket 213 described with reference to FIGS. 4 and 5, the fixed bracket 413 may have a shape that is the same as or similar to the shape of the fixed bracket 213, but may be longer in the y-axis direction than the fixed bracket 213 such that two helical gears 433a and 433b are disposed on the fixed bracket 413. At least a part of the detent structure 440 may include a cam member 441 cam-coupled with sides of the arm parts 421 and 422 and elastic members 442a and 442b that provide elastic forces to the cam member 441, and a shaft bracket 443b. The detent structure 440 may have a structure that is the same as or similar to that of the detent structure 340 described above with reference to FIG. 12. According to various embodiments, the detent structure 440 may be replaced with the detent structure 240 described above with reference to FIGS. 4 and 5.

The gear structure 430 may include a first shaft gear 431_2 disposed on a first rotary shaft 431, a second shaft gear 432_2 disposed on a second rotary shaft 432, the first helical gear 433a engaged (or coupled) with the first shaft gear 431_2, and the second helical gear 433b engaged (or coupled) with the first helical gear 433a and the second rotary shaft 432. The first helical gear 433a and the second helical gear 433b may have a form that is the same as or similar to that of the helical gear 233 described above with reference to FIGS. 4 and 5, differing only in the gear pattern direction and the size. According to an embodiment, one of the first helical gear 433a and the second helical gear 433b may have the same helical gear pattern direction as the helical gear 233, and the other may have a helical gear pattern direction different from that of the helical gear 233.

The direction of a gear pattern 431_2a of the first shaft gear 431_2 may be opposite to the direction of a gear pattern 432_2a of the second shaft gear 432_2. For example, the first shaft gear 431_2 may have the gear pattern 431_2a in which ridges and valleys are disposed in a diagonal direction between the -x-axis and the -y-axis, and the second shaft gear 432_2 may have the gear pattern 432_2a in which ridges and valleys are disposed in a diagonal direction between the -x-axis and the y-axis. For example, the first helical gear 433a may have a gear pattern 433a_2a in which ridges and valleys are disposed in a diagonal direction between the z-axis and the -y-axis, and the second helical gear 433b may have a gear pattern 433b_2a in which ridges and valleys are disposed in a diagonal direction between the z-axis and the y-axis.

In the gear structure 430 having the above-described structure, when the first rotary member 411 and the second rotary member 412 move in the z-axis direction as the electronic device is changed from an unfolded state to a folded state, the first shaft gear 431_2 may rotate about the -x-axis in the counterclockwise direction, the first helical gear 433a engaged (or coupled) with the first shaft gear 431_2 so as to be perpendicular to the first shaft gear 431_2 may rotate about the z-axis in the clockwise direction, the second helical gear 433b horizontally engaged (or coupled) with the first helical gear 433a may rotate about the z-axis in the counterclockwise direction, and the second shaft gear 432_2 engaged (or coupled) with the second helical gear 433b so as to be perpendicular to the second helical gear 433b may rotate about the -x-axis in the clockwise direction. The gear structure 430 may perform an opposite operation when the electronic device is changed from the folded state to the unfolded state. For example, when the electronic device is changed from the folded state to the unfolded state, the first shaft gear 431_2 may rotate about the -x-axis in the clockwise direction, the first helical gear 433a engaged (or coupled) with the first shaft gear 431_2 so as to be perpendicular to the first shaft gear 431_2 may rotate about the z-axis in the counterclockwise direction, the second helical gear 433b horizontally engaged (or coupled) with the first helical gear 433a may rotate about the z-axis in the clockwise direction, and the second shaft gear 432_2 engaged (or coupled) with the second helical gear 433b so as to be perpendicular to the second helical gear 433b may rotate about the -x-axis in the counterclockwise direction.

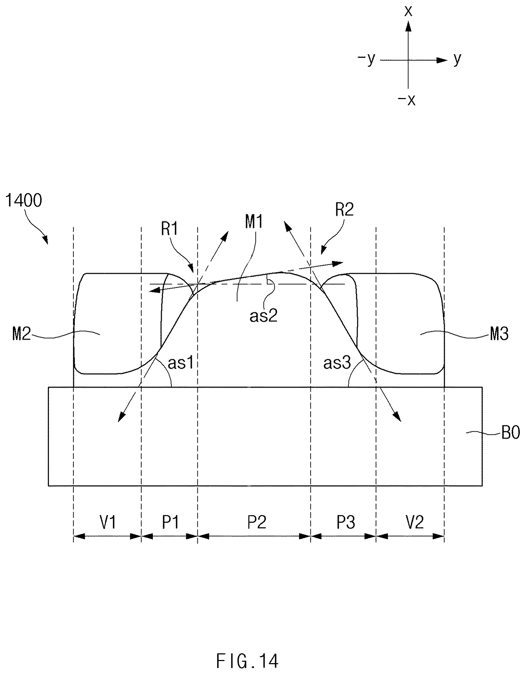

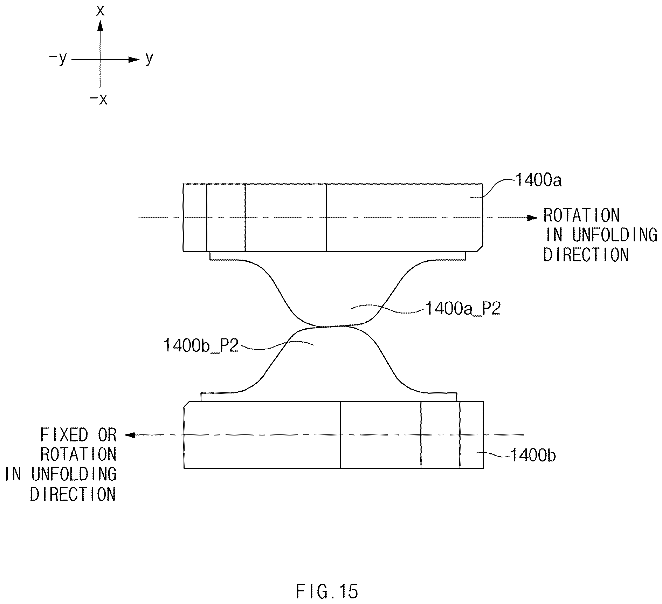

FIG. 14 is a view illustrating another example of a cam shape according to various embodiments, and FIG. 15 is a view illustrating one example of a contact state of some ridges of a cam and a cam structure according to various embodiments. Prior to description, cams 1400, 1400a, and 1400b according to embodiments may be applied to at least one of the cams or the cam structures described above with reference to FIGS. 4, 5, 10, 12, and 13.

Referring to FIG. 14, the cam 1400 (or, the cam structure) according to an embodiment may include a cam support portion B0, a plurality of ridges M1, M2, and M3, and a plurality of valleys V1 and V2. In the illustrated drawing, the cam 1400 including three ridges M1, M2, and M3 and three valleys V1 and V2 (a valley hidden by the first ridge M1 not being illustrated) is illustrated. However, the disclosure is not limited thereto. For example, the cam 1400 may have a structure including two or more cams and valleys. The plurality of ridges M1, M2, and M3 may all have the same structure. Alternatively, at least one of the plurality of ridges M1, M2, and M3 may have a different form from the other ridges. For example, as illustrated, at least one ridge may have a structure (an inclined portion) in which a second portion P2 corresponding to the center of the ridge is inclined at a predetermined inclination angle (an inclination angle greater than 0 degrees, for example, about 5 degrees), and at least one other ridge may have a structure in which the central portion of the ridge is flat (e.g., an inclination angle of 0 degrees).

According to an embodiment, as illustrated, at least one ridge among the plurality of valleys M1, M2, and M3, for example, the first ridge M1 may include a first portion P1 (or, a first inclined portion) having a first inclination angle as1, the second portion P2 (or, the second inclined portion) having a second inclination angle as2, and a third portion P3 (or, a third inclined portion) having a third inclination angle as3. One side (e.g., an end facing in the -y-axis direction) of the first portion P1 may be connected to one side (e.g., an end facing in the y-axis direction) of the first valley V1, and an opposite side (e.g., an end facing in the y-axis direction) of the first portion P1 may be connected to one side (e.g., an end facing in the -y-axis direction) of the second portion P2. The first portion P1 may be constituted by, for example, a ridge line having the first inclination angle as1 based on the y-axis. The first inclination angle as1 may include an acute angle smaller than 90 degrees in the direction from the - y-axis to the y-axis based on the x-axis.

The one side (e.g., the end facing in the -y-axis direction) of the second portion P2 may be connected to the opposite side (e.g., the end facing in the y-axis direction) of the first portion P1, and an opposite side (e.g., an end facing in the y-axis direction) of the second portion P2 may be connected to one side (e.g., an end facing in the -y-axis direction) of the third portion P3. The second portion P2 may further protrude beyond the first portion P1 and the third portion P3 in the x-axis direction. The border region between the first portion P1 and the second portion P2 may be rounded with a specified first curvature R1. The second portion P2 may have the second inclination angle as2 based on the y-axis. The second inclination angle as2 may include an acute angle smaller than 90 degrees in the direction from the -y-axis to the y-axis based on the x-axis, and the absolute value of the second inclination angle as2 may be smaller than the absolute value of the first inclination angle as1.

The one side (e.g., the end facing in the -y-axis direction) of the third portion P3 may be connected to the opposite side (e.g., the end facing in the y-axis direction) of the second portion P2, and an opposite side (e.g., an end facing in the y-axis direction) of the third portion P3 may be connected to one side (e.g., an end facing in the -y-axis direction) of the second valley V2. The third portion P3 may be formed to have a predetermined inclination from the second portion P2 toward the y-axis. The border region between the second portion P2 and the third portion P3 may be rounded with a specified second curvature R2. The second curvature R2 may be smaller than the first curvature R1 (e.g., the first curvature R1 being gentler than the second curvature R2). The third portion P3 may have the third inclination angle as3 based on the -y-axis. The third inclination angle as3 may include an acute angle smaller than 90 degrees in the direction from the y-axis to the -y-axis based on the x-axis, and the absolute value of the third inclination angle as3 may be greater than the absolute value of the second inclination angle as2. According to various embodiments, the absolute value of the third inclination angle as3 may be greater than or equal to the absolute value of the first inclination angle as1.

Referring to FIG. 15, a protrusion of the cam 1400a may be disposed to protrude in the direction from the x-axis to the -x-axis, and a protrusion of the cam structure 1400b may be disposed to protrude in the direction from the -x-axis to the x-axis. Alternatively, a bumpy structure of the cam 1400a and a bumpy structure of the cam structure 1400b may be disposed to face each other. As illustrated, at least part of a second portion 1400a_P2 of the cam 1400a and at least part of a second portion 1400b_P2 of the cam structure 1400b may make contact with each other while an electronic device (e.g., the electronic device 100 of FIG. 1) is in a free-stop section (a section in which the electronic device is mounted in a specified angle range by friction between the cam 1400a and the cam structure 1400b). According to an embodiment, when the electronic device has a free-stop state in which the electronic device is temporarily stopped at a specified angle between the folded state and the unfolded state described with reference to FIG. 11 (or, a state in which the electronic device maintains the current state before application of additional pressure), a display (e.g., the display 160 of FIG. 1) may exert a repulsive force to return to the unfolded state (the state of FIG. 12).

According to an embodiment, the cam 1400a may be pushed in the y-axis direction by the restoring force of the display (e.g., the repulsive force of the display acts in the counterclockwise direction), and the cam structure 1400b may be pushed in the -y-axis direction by the restoring force of the display (e.g., the repulsive force of the display acts in the clockwise direction). According to various embodiments, the cam 1400a may remain fixed, and the cam structure 1400b (e.g., the cam structure disposed on the first arm part 221 or the second arm part 222) may be pushed.

Because the second portion 1400a_P2 of the cam 1400a and the second portion 1400b_p2 of the cam structure 1400b make contact with each other with the above-described second inclination angle as2 in this process, the cam 1400a and the cam structure 1400b of the disclosure may cancel out at least a portion of the repulsive force (or, the restoring force) generated in the unfolding direction of the display, thereby suppressing a push in the free-stop state that is likely to occur regardless of a user's intention (e.g., a change of the angle between a first housing (e.g., the first housing 110 of FIG. 1) and a second housing (e.g., the second housing 120 of FIG. 1)).

According to various embodiments, as in FIG. 11, the electronic device may have a mounting state of a specific angle (or, a free-stop state) between the folded state and the unfolded state. In this case, as the cam 1400a and the cam structure 1400b are disposed such that inclined portions having inclination angles are engaged with each other as illustrated, the repulsive force or the restoring force of the display may cancel out a force acting toward the unfolded state as in FIG. 15. Although FIG. 15 illustrates the structure in which the top portions of the ridges of the cam 1400a and the cam structure 1400b have the second inclination angle as2, the disclosure is not limited thereto. For example, the second portion P2 having the second inclination angle as2 may be formed on only one of the cam 1400a and the cam structure 1400b.

Meanwhile, in FIG. 15, the rotation in the unfolding direction has been described based on the direction in which the cam structure 1400b rotates from the -y-axis (or, the left) to the y-axis (or, the right). However, the disclosure is not limited thereto. For example, depending on the design form of the electronic device, the direction in which the cam structure 1400b rotates may be a direction in which the display operates from the folded state to the unfolded state. In this case, the inclination angle of the protrusions of the cam structure 1400b and the cam 1400a may be formed in a direction that cancels out a force (or pressure) by which the display is unfolded.

The cam or the cam structure of FIGS. 14 and 15 may be applied to at least one of the cams or at least one of the cam structures described above with reference to FIGS. 4, 5, 10, 12, and 13. For example, the shape of the cam 1400 having the inclination angles described with reference to FIG. 14 may be applied to at least one of the cam structures 221_3a, 221_4a, 221_4b, and 221_5a of the first arm part 221 and at least one of the cam structures 222_3a, 222_4a, 222_4b, and 222_5a of the second arm part 221 described above with reference to FIG. 5. Since the first arm part 221 and the second arm part 221 rotate in opposite directions, the direction of the inclination (or, the inclination angle) of the inclined portion applied to the cam structures 221_3a, 221_4a, 221_4b, and 221_5a of the first arm part 221 and the direction of the inclination (or, the inclination angle) of the inclined portion applied to the cam structures 2221_3a, 2221_4a, 2221_4b, and 2221_5a of the second arm part 222 may be opposite directions (or, directions symmetrical to each other with respect to the -x-axis or the x-axis). According to an embodiment, at least portions of the upper ends of the protrusions of the cam structures 221_3a, 221_4a, 221_4b, and 221_5a of the first arm part 221 may include an inclined portion having an inclination angle greater than 0 degrees in the clockwise direction (or, in the counterclockwise direction), and at least portions of the upper ends of the protrusions of the cam structures 222_3a, 222_4a, 222_4b, and 222_5a of the second arm part 222 may include an inclined portion having an inclination angle greater than 0 degrees in the counterclockwise direction (or, in the clockwise direction).

According to various embodiments, the shape of the cam 1400 having the inclination angles described with reference to FIG. 14 may be applied to at least one of the cams 241a_2a, 241a_2b, 241b_2a, 241b_2b, 241c_2a, 241c_2b, 241d_2a, 241d_2b of FIG. 5 described above. Here, when the shape of the cam 1400 having the inclination angles described with reference to FIG. 14 is applied to two cams disposed on one cam member (e.g., 241a, 241b, 241c, or 241d), directions of the inclination angles may be opposite to each other. For example, in FIG. 5, when at least a portion of the upper end of the protrusion of the first cam 241a_2a has an inclination angle greater than 0 degrees in the clockwise direction (or, in the counterclockwise direction) based on the x-axis in the first cam member 241a, at least a portion of the upper end of the protrusion of the second cam 241a_2b may be formed to have an inclination angle greater than 0 degrees in the counterclockwise direction (or, in the clockwise direction). Similarly, when at least portions of the upper ends of the protrusions of some cams 241b_2a, 241c_2a, 241d_2a have an inclination angle greater than 0 degrees in the clockwise direction (or, in the counterclockwise direction), at least portions of the upper ends of the protrusions of the other cams 241b_2b, 241c_2b, 241d_2b may be formed to have an inclination angle greater than 0 degrees in the counterclockwise direction (or, in the clockwise direction).

According to various embodiments, when at least portions of the upper ends of the protrusions of the cam structures (at least one of 221_3a, 221_4a, 221_4b, or 221_5a) of the first arm part 221 have an inclination angle greater than 0 degrees in the clockwise direction (or, in the counterclockwise direction) based on the x-axis, at least portions of the uppers end of some cams (at least one of 241a_2a, 241b_2a, 241c_2a, or 241d_2a) may be formed to have an inclination angle greater than 0 degrees in the counterclockwise direction (or, in the clockwise direction) based on the x-axis. When at least portions of the upper ends of the protrusions of the cam structures (at least one of 222_3a, 222_4a, 222_4b, or 222_5a) of the second arm part 222 have an inclination angle greater than 0 degrees in the counterclockwise direction (or, in the clockwise direction) based on the x-axis, at least portions of the uppers end of the other cams (at least one of 241a_2b, 241b_2b, 241c_2b, or 241d_2b) may be formed to have an inclination angle greater than 0 degrees in the clockwise direction (or, in the counterclockwise direction) based on the x-axis.

According to various embodiments, in the electronic device, when the housing 101 is in an at least partially folded state, the display may have a restoring force from the at least partially folded state to an unfolded state, and the restoring force may be applied to the hinge structure. Accordingly, at least one first cam disposed on a arm part (e.g., the first arm part or the second arm part) may rotate in the clockwise direction, at least one second cam disposed on a cam member (e.g., the cam members 241a, 241b, 241c, and 241d) may rotate in the counterclockwise direction, an inclination may be formed at the center of the ridge of the at least one first cam such that a second side facing in the counterclockwise direction is higher than a first side facing in the clockwise direction, and an inclination may be formed at the center of the ridge of the at least one second cam such that a second side facing in the counterclockwise direction is lower than a first side facing in the clockwise direction.

According to the various embodiments described above, an electronic device according to an embodiment may include a foldable display 160, a first housing 110, a second housing 120, and a hinge structure 200a or 200b that connects the first housing and the second housing. The hinge structure may include a first rotary member 211 fastened (or coupled) to the first housing, a second rotary member 212 fastened (or coupled) to the second housing, a first arm part 221 that rotates along the first rotary member based on a sliding operation when the first rotary member rotates, a second arm part 222 that rotates along the second rotary member based on a sliding operation when the second rotary member rotates, a fixed bracket 213 on which the first rotary member and the second rotary member are seated, a helical gear 233 seated on one side of the fixed bracket, a first rotary shaft coupled to the first arm part, a first shaft gear 232_1 disposed on one side of the first rotary shaft and engaged with one side of the helical gear, a second rotary shaft coupled to the second arm part, and a second shaft gear 232_1 disposed on one side of the second rotary shaft and engaged with an opposite side of the helical gear.

According to various embodiments, the fixed bracket may include a first rail recess 213_2a to which a first rail formed on the first rotary member is coupled, a second rail recess 213_2b to which a second rail formed on the second rotary member is coupled, an opening 213_4c in which at least a portion of the helical gear is seated, and a first extension 213_4a and a second extension 213_4b that are spaced apart from each other by a predetermined gap to form the opening and that guide lateral portions of the helical gear.

According to various embodiments, the helical gear may include a first gear body 233_1 that is disposed on a surface facing in a direction perpendicular to a front surface of the foldable display and that has a gear pattern 233_6 formed on at least a portion of a side surface thereof, a second gear body 233_2 spaced apart from the first gear body by a predetermined gap and disposed side by side with the first gear body, and a pillar portion 233_5 disposed between the first gear body and the second gear body.

According to various embodiments, the helical gear may further include a hole 233_4 that penetrates the center of the pillar portion and a strap-shaped groove 233_3 that is formed between the first gear body and the second gear body and to which at least a portion of the first extension and at least a portion of the second extension are fastened (or coupled) to prevent (or limit) movement of the helical gear.

According to various embodiments, the fixed bracket may include a first mounting recess 213_3a in which at least a portion of a first shaft mounting portion 231_3 that extends from one end of the first shaft gear is seated, a third extension 213_5a that guides the first shaft gear, a second mounting recess 213_3b in which at least a portion of a second shaft mounting portion 232_3 that extends from one end of the second shaft gear is seated, and a fourth extension 213_5b that guides the second shaft gear.

According to various embodiments, the electronic device may further include a center bracket 243a fastened (or coupled) with the fixed bracket. The center bracket may include a center body 243a_1, a first bracket wing part 243a_2 that is formed on one side of the center body and into which the first rotary shaft is inserted, and a second bracket wing part 243a_3 that is formed on an opposite side of the center body and into which the second rotary shaft is inserted.

According to various embodiments, the electronic device may further include a hinge housing in which at least a portion of the hinge structure is seated, and the center bracket may further include a center hole 243a_1a into which at least a portion of a fastening member that fixes the center body to the hinge housing is inserted.

According to various embodiments, the center bracket may further include a gear mounting part 243a_4 fastened (or coupled) to the opening between the first extension 213_4a and the second extension 213_4b and used to prevent (or limit) movement of the helical gear and a first protrusion 243a_22a and a second protrusion 243a_32a coupled with the third extension and the fourth extension.

According to various embodiments, a gear pattern 231_2a of the first shaft gear and a gear pattern 232_2a of the second shaft gear may be formed in the same direction.

According to various embodiments, in an operation in which the first housing and the second housing are folded, while the helical gear rotates in the clockwise direction based on a direction perpendicular to a front surface of the foldable display, the first shaft gear may rotate in the counterclockwise direction, and the second shaft gear may rotate in the clockwise direction.

According to various embodiments, in an operation in which the first housing and the second housing are unfolded, while the helical gear rotates in the counterclockwise direction based on a direction perpendicular to a front surface of the foldable display, the first shaft gear may rotate in the clockwise direction, and the second shaft gear may rotate in the counterclockwise direction.

According to various embodiments, the helical gear may include a first helical gear 433_a and a second helical gear 433b having a different helical direction from the first helical gear.

According to various embodiments, a direction of a gear pattern 431_2a of the first shaft gear 431_2 adjacent to the first helical gear and a direction of a gear pattern 432_2a of the second shaft gear 432_2 adjacent to the second helical gear may differ from each other.

According to various embodiments, in an operation in which the first housing and the second housing are folded, the first shaft gear may rotate in the counterclockwise direction base on an axial direction parallel to the foldable display, the first helical gear engaged with the first shaft gear so as to be perpendicular to the first shaft gear may rotate in the clockwise direction, the second helical gear engaged with the first helical gear may rotate in the counterclockwise direction, and the second shaft gear coupled with the first helical gear so as to be perpendicular to the first helical gear may rotate in the clockwise direction.

According to various embodiments, in an operation in which the first housing and the second housing are unfolded, the first shaft gear may rotate in the clockwise direction base on an axial direction parallel to the foldable display, the first helical gear engaged with the first shaft gear so as to be perpendicular to the first shaft gear may rotate in the counterclockwise direction, the second helical gear engaged with the first helical gear may rotate in the clockwise direction, and the second shaft gear coupled with the first helical gear so as to be perpendicular to the first helical gear may rotate in the counterclockwise direction.

According to various embodiments, the electronic device may further include a first cam structure and a second cam structure disposed on the first arm part, a third cam structure and a fourth cam structure disposed on the second arm part, a first cam member including a first cam engaged with the first cam structure and a second cam engaged with the third cam structure, and a second cam member including a third cam engaged with the second cam structure and a fourth cam engaged with the fourth cam structure.

According to various embodiments, the first cam member may include a first cam body 241a_1, a first cam hole 241a_4a that is formed on one side of the first cam body and into which a portion of the first rotary shaft having a first elastic member 242a mounted thereon is inserted, and a second cam hole 241a_4b that is formed on an opposite side of the first cam body and into which a portion of the second rotary shaft having a second elastic member 242d mounted thereon is inserted.

According to various embodiments, the first cam member may further include a first elastic-body mounting protrusion 241a_3a that is formed on one side of the first cam body and on which one side of a third elastic member 242b is mounted and a second elastic-body mounting protrusion 241a_3b that is formed on the first cam body and spaced apart from the first elastic-body mounting protrusion and on which one side of a fourth elastic member 242c is mounted.

According to various embodiments, at least a portion of an upper end of a protrusion of at least one cam structure disposed on the first arm part and formed in a bumpy structure may include a first inclined portion having an inclination of a specified magnitude in a first direction in which the display is changed from a folded state to an unfolded state, at least a portion of an upper end of a protrusion of at least one cam engaged with at least one cam structure of the first arm part may include a second inclined portion having an inclination in a direction opposite to a direction of the inclination of the first inclined portion, at least a portion of an upper end of a protrusion of at least one cam structure disposed on the second arm part and formed in a bumpy structure may include a third inclined portion having an inclination of a specified magnitude in a direction opposite to the first direction, and at least a portion of an upper end of a protrusion of at least one cam engaged with at least one cam structure of the second arm part may include a fourth inclined portion having an inclination in a direction opposite to a direction of the inclination of the third inclined portion.

According to various embodiments, an electronic device according to an embodiment may include a first rotary member 211 fastened to a first housing, a second rotary member 212 fastened to a second housing, a first arm part 221 that rotates along the first rotary member based on a sliding operation when the first rotary member rotates, a second arm part 222 that rotates along the second rotary member based on a sliding operation when the second rotary member rotates, a fixed bracket 213 on which the first rotary member and the second rotary member are seated, a helical gear 233 seated on one side of the fixed bracket, a first rotary shaft coupled to the first arm part, a first shaft gear 232_1 disposed on one side of the first rotary shaft and engaged with one side of the helical gear, a second rotary shaft coupled to the second arm part, and a second shaft gear 232_1 disposed on one side of the second rotary shaft and engaged with an opposite side of the helical gear.

Each component (e.g., a module or a program) according to various embodiments may be composed of single entity or a plurality of entities, a part of the above-described sub-components may be omitted, or other sub-components may be further included in various embodiments. Alternatively or additionally, after being integrated in one entity, some components (e.g., a module or a program) may identically or similarly perform the function executed by each corresponding component before integration. According to various embodiments, operations executed by modules, program, or other components may be executed by a successive method, a parallel method, a repeated method, or a heuristic method, or at least one part of operations may be executed in different sequences or omitted. Alternatively, other operations may be added.

## Claims

1. An electronic device comprising:
a foldable display 160;
a first housing 110;
a second housing 120; and
a hinge structure 200a or 200b configured to connect the first housing and the second housing,
wherein the hinge structure includes:
a first rotary member 211 coupled to the first housing;
a second rotary member 212 coupled to the second housing;
a first arm part 221 connected to the first rotary member ;
a second arm part 222 connected to the second rotary member ;
a fixed bracket 213 on which the first rotary member and the second rotary member are seated;
a helical gear 233 seated on one side of the fixed bracket;
a first rotary shaft 231 coupled to the first arm part 221 and a first shaft gear 231_1 disposed on one side of the first rotary shaft 231 and engaged with one side of the helical gear; and
a second rotary shaft 232 coupled to the second arm part 222 and a second shaft gear 232_1 disposed on one side of the second rotary shaft 232 and engaged with an opposite side of the helical gear;
wherein, in response to a rotation of the first rotary member, the first arm part (221) rotates in conjunction with the first rotary member while sliding along at least a part of a lateral portion of the first rotatory member; and
in response to a rotation of the second rotary member, the second arm part (222) rotates in conjunction with the second rotary member while sliding along at least a part of a lateral portion of the second rotatory member.

2. The electronic device of claim 1, wherein the fixed bracket includes:
a first rail recess 213_2a to which a first rail formed on the first rotary member is coupled;
a second rail recess 213_2b to which a second rail formed on the second rotary member is coupled;
an opening 213_4c in which at least a portion of the helical gear is seated; and
a first extension 213_4a and a second extension 213_4b spaced apart from each other by a predetermined gap to form the opening and configured to guide lateral portions of the helical gear.

3. The electronic device of claim 2, wherein the helical gear includes:
a first gear body 233_1 disposed on a surface facing in a direction perpendicular to a front surface of the foldable display, the first gear body 233_1 having a gear pattern 233_6 formed on at least a portion of a side surface thereof;
a second gear body 233_2 spaced apart from the first gear body by a predetermined gap and disposed side by side with the first gear body; and
a pillar portion 233_5 disposed between the first gear body and the second gear body.

4. The electronic device of claim 3, wherein the helical gear further includes:
a hole 233_4 configured to penetrate the center of the pillar portion; and
a strap-shaped groove 233_3 formed between the first gear body and the second gear body, wherein at least a portion of the first extension and at least a portion of the second extension are coupled to the strap-shaped groove to limit movement of the helical gear.

5. The electronic device of claim 4, wherein the fixed bracket includes:
a first mounting recess 213_3a in which at least a portion of a first shaft mounting portion 231_3 configured to extend from one end of the first shaft gear is seated;
a third extension 213_5a configured to guide the first shaft gear;
a second mounting recess 213_3b in which at least a portion of a second shaft mounting portion 232_3 configured to extend from one end of the second shaft gear is seated; and
a fourth extension 213_5b configured to guide the second shaft gear.

6. The electronic device of claim 5, further comprising:
a center bracket 243a coupled with the fixed bracket,
wherein the center bracket includes:
a center body 243a_1;
a first bracket wing part 243a_2 formed on one side of the center body, the first rotary shaft being inserted into the first bracket wing part 243a_2; and
a second bracket wing part 243a_3 formed on an opposite side of the center body, the second rotary shaft being inserted into the second bracket wing part 243a_3.

7. The electronic device of claim 6, further comprising:
a hinge housing in which at least a portion of the hinge structure is seated,
wherein the center bracket further includes a center hole 243a_1a into which at least a portion of a fastening member configured to fix the center body to the hinge housing is inserted.

8. The electronic device of claim 6, wherein the center bracket further includes:
a gear mounting part 243a_4 coupled to the opening between the first extension 213_4a and the second extension 213_4b and used to limit movement of the helical gear; and
a first protrusion 243a_22a and a second protrusion 243a_32a coupled with the third extension and the fourth extension.

9. The electronic device of claim 1, wherein a gear pattern 231_2a of the first shaft gear and a gear pattern 232_2a of the second shaft gear are formed in the same direction.

10. The electronic device of claim 9, wherein in an operation in which the first housing and the second housing are folded, while the helical gear rotates in the clockwise direction based on a direction perpendicular to a front surface of the foldable display, the first shaft gear rotates in the counterclockwise direction, and the second shaft gear rotates in the clockwise direction.

11. The electronic device of claim 9, wherein in an operation in which the first housing and the second housing are unfolded, while the helical gear rotates in the counterclockwise direction based on a direction perpendicular to a front surface of the foldable display, the first shaft gear rotates in the clockwise direction, and the second shaft gear rotates in the counterclockwise direction.

12. The electronic device of claim 1, wherein the helical gear includes a first helical gear 433_a and a second helical gear 433b having a different helical direction from the first helical gear.

13. The electronic device of claim 12, wherein a direction of a gear pattern 431_2a of the first shaft gear 431_2 adjacent to the first helical gear and a direction of a gear pattern 432_2a of the second shaft gear 432_2 adjacent to the second helical gear differ from each other.

14. The electronic device of claim 13, wherein in an operation in which the first housing and the second housing are folded,
the first shaft gear rotates in the counterclockwise direction based on an axial direction parallel to the foldable display,
the first helical gear engaged with the first shaft gear so as to be perpendicular to the first shaft gear rotates in the clockwise direction,
the second helical gear engaged with the first helical gear rotates in the counterclockwise direction, and
the second shaft gear coupled with the first helical gear so as to be perpendicular to the first helical gear rotates in the clockwise direction.

15. The electronic device of claim 13, wherein in an operation in which the first housing and the second housing are unfolded,
the first shaft gear rotates in the clockwise direction base on an axial direction parallel to the foldable display,
the first helical gear engaged with the first shaft gear so as to be perpendicular to the first shaft gear rotates in the counterclockwise direction,
the second helical gear engaged with the first helical gear rotates in the clockwise direction, and
the second shaft gear coupled with the first helical gear so as to be perpendicular to the first helical gear rotates in the counterclockwise direction.

## Patentansprüche

1. Elektronische Vorrichtung, umfassend:
eine faltbare Anzeige 160;
ein erstes Gehäuse 110;
ein zweites Gehäuse 120; und
eine Gelenkstruktur 200a oder 200b, die dazu konfiguriert ist, das erste Gehäuse und das zweite Gehäuse zu verbinden,
wobei die Gelenkstruktur beinhaltet:
ein erstes Drehelement 211, das an das erste Gehäuse gekoppelt ist;
ein zweites Drehelement 212, das an das zweite Gehäuse gekoppelt ist;
ein erstes Armteil 221, das mit dem ersten Drehelement verbunden ist;
ein zweites Armteil 222, das mit dem zweiten Drehelement verbunden ist;
eine feste Halterung 213, auf der das erste Drehelement und das zweite Drehelement sitzen;
ein schrägverzahntes Zahnrad 233, das auf einer Seite der festen Halterung sitzt;
eine erste Drehwelle 231, die an das erste Armteil 221 gekoppelt ist, und ein erstes Wellenzahnrad 231_1, das auf einer Seite der ersten Drehwelle 231 angeordnet ist und mit einer Seite des schrägverzahnten Zahnrads in Eingriff steht; und
eine zweite Drehwelle 232, die an das zweite Armteil 222 gekoppelt ist, und ein zweites Wellenzahnrad 232_1, das auf einer Seite der zweiten Drehwelle 232 angeordnet ist und mit einer gegenüberliegenden Seite des schrägverzahnten Zahnrads in Eingriff steht;
wobei, als Reaktion auf eine Drehung des ersten Drehelements, sich das erste Armteil (221) gemeinsam mit dem ersten Drehelement dreht, während es entlang mindestens eines Teils eines seitlichen Abschnitts des ersten Drehelements gleitet; und,
als Reaktion auf eine Drehung des zweiten Drehelements, sich das zweite Armteil (222) gemeinsam mit dem zweiten Drehelement dreht, während es entlang mindestens eines Teils eines seitlichen Abschnitts des zweiten Drehelements gleitet.

2. Elektronische Vorrichtung nach Anspruch 1, wobei die feste Halterung beinhaltet:
eine erste Schienenaussparung 213_2a, an die eine erste Schiene, die auf dem ersten Drehelement gebildet ist, gekoppelt ist;
eine zweite Schienenaussparung 213_2b, an die eine zweite Schiene, die auf dem zweiten Drehelement gebildet ist, gekoppelt ist;
eine Öffnung 213_4c, in der mindestens ein Abschnitt des schrägverzahnten Zahnrads sitzt; und
eine erste Verlängerung 213_4a und eine zweite Verlängerung 213_4b, die um einen vorbestimmten Spalt voneinander beabstandet sind, um die Öffnung zu bilden, und dazu konfiguriert sind, seitliche Abschnitte des schrägverzahnten Zahnrads zu führen.

3. Elektronische Vorrichtung nach Anspruch 2, wobei das schrägverzahnte Zahnrad beinhaltet:einen ersten Zahnradkörper 233 _1, der auf einer Fläche angeordnet ist, die in eine Richtung senkrecht zu einer Vorderfläche der faltbaren Anzeige zeigt, wobei der erste Zahnradkörper 233_1 ein Zahnradmuster 233_6 aufweist, das auf mindestens einem Abschnitt einer Seitenfläche davon gebildet ist;
einen zweiten Zahnradkörper 233_2, der um einen vorbestimmten Spalt von dem ersten Zahnradkörper beabstandet und Seite an Seite mit dem ersten Zahnradkörper angeordnet ist; und
einen Säulenabschnitt 233_5, der zwischen dem ersten Zahnradkörper und dem zweiten Zahnradkörper angeordnet ist.

4. Elektronische Vorrichtung nach Anspruch 3, wobei das schrägverzahnte Zahnrad ferner beinhaltet:
ein Loch 233_4, das dazu konfiguriert ist, die Mitte des Säulenabschnitts zu durchdringen; und
eine riemenförmige Nut 233_3, die zwischen dem ersten Zahnradkörper und dem zweiten Zahnradkörper gebildet ist, wobei mindestens ein Abschnitt der ersten Verlängerung und mindestens ein Abschnitt der zweiten Verlängerung an die riemenförmige Nut gekoppelt sind, um eine Bewegung des schrägverzahnten Zahnrads zu begrenzen.

5. Elektronische Vorrichtung nach Anspruch 4, wobei die feste Halterung beinhaltet:
eine erste Montageaussparung 213_3a, in der mindestens ein Abschnitt eines ersten Wellenmontageabschnitts 231_3, der dazu konfiguriert ist, sich von einem Ende des ersten Wellenzahnrads zu erstrecken, sitzt;
eine dritte Verlängerung 213_5a, die dazu konfiguriert ist, das erste Wellenzahnrad zu führen;
eine zweite Montageaussparung 213_3b, in der mindestens ein Abschnitt eines zweiten Wellenmontageabschnitts 232_3, der dazu konfiguriert ist, sich von einem Ende des zweiten Wellenzahnrads zu erstrecken, sitzt; und
eine vierte Verlängerung 213_5b, die dazu konfiguriert ist, das zweite Wellenzahnrad zu führen.

6. Elektronische Vorrichtung nach Anspruch 5, ferner umfassend:
eine mittlere Halterung 243a, die mit der festen Halterung gekoppelt ist,
wobei die mittlere Halterung beinhaltet:
einen mittleren Körper 243a_1;
ein erstes Halterungsflügelteil 243a_2, das auf einer Seite des mittleren Körpers gebildet ist, wobei die erste Drehwelle in das erste Halterungsflügelteil 243a_2 eingesetzt wird; und
ein zweites Halterungsflügelteil 243a_3, das auf einer gegenüberliegenden Seite des mittleren Körpers gebildet ist, wobei die zweite Drehwelle in den zweiten Halterungsflügelteil 243a_3 eingesetzt wird.

7. Elektronische Vorrichtung nach Anspruch 6, ferner umfassend:
ein Gelenkgehäuse, in dem mindestens ein Abschnitt der Gelenkstruktur sitzt,wobei die mittlere Halterung ferner ein mittleres Loch 243a_1a beinhaltet, in das mindestens ein Abschnitt eines Befestigungselements, das dazu konfiguriert ist, den mittleren Körper an dem Gelenkgehäuse zu befestigen, eingesetzt ist.

8. Elektronische Vorrichtung nach Anspruch 6, wobei die mittleren Halterung ferner beinhaltet:
ein Zahnradmontageteil 243a_4, das an die Öffnung zwischen der ersten Verlängerung 213_4a und der zweiten Verlängerung 213_4b gekoppelt ist und verwendet wird, um eine Bewegung des schrägverzahnten Zahnrads zu begrenzen; und
einen ersten Vorsprung 243a_22a und einen zweiten Vorsprung 243a_32a, die mit der dritten Verlängerung und der vierten Verlängerung gekoppelt sind.

9. Elektronische Vorrichtung nach Anspruch 1, wobei ein Zahnradmuster 231_2a des ersten Wellenzahnrads und ein Zahnradmuster 232_2a des zweiten Wellenzahnrads in derselben Richtung gebildet sind.

10. Elektronische Vorrichtung nach Anspruch 9, wobei in einem Vorgang, in dem das erste Gehäuse und das zweite Gehäuse gefaltet werden, während sich das schrägverzahnte Zahnrad basierend auf einer Richtung senkrecht zu einer Vorderfläche der faltbaren Anzeige im Uhrzeigersinn dreht, sich das erste Wellenzahnrad im Gegenuhrzeigersinn dreht und sich das zweite Wellenzahnrad im Uhrzeigersinn dreht.

11. Elektronische Vorrichtung nach Anspruch 9, wobei in einem Vorgang, in dem das erste Gehäuse und das zweite Gehäuse aufgefaltet werden, während sich das schrägverzahnte Zahnrad basierend auf einer Richtung senkrecht zu einer Vorderfläche der faltbaren Anzeige im Gegenuhrzeigersinn dreht, sich das erste Wellenzahnrad im Uhrzeigersinn dreht und sich das zweite Wellenzahnrad im Gegenuhrzeigersinn dreht.

12. Elektronische Vorrichtung nach Anspruch 1, wobei das schrägverzahnte Zahnrad ein erstes schrägverzahntes Zahnrad 433_a und ein zweites schrägverzahntes Zahnrad 433b mit einer Spiralrichtung, die sich von dem ersten schrägverzahnten Zahnrad unterscheidet, beinhaltet.

13. Elektronische Vorrichtung nach Anspruch 12, wobei sich eine Richtung eines Zahnradmusters 431_2a des ersten Wellenzahnrads 431_2 benachbart zu dem ersten schrägverzahnten Zahnrad und eine Richtung eines Zahnradmusters 432_2a des zweiten Wellenzahnrads 432_2 benachbart zu dem zweiten schrägverzahnten Zahnrad voneinander unterscheiden.

14. Elektronische Vorrichtung nach Anspruch 13, wobei in einem Vorgang, in dem das erste Gehäuse und das zweite Gehäuse gefaltet werden,
sich das erste Wellenzahnrad basierend auf einer axialen Richtung parallel zu der faltbaren Anzeige im Gegenuhrzeigersinn dreht,
das erste schrägverzahnte Zahnrad, das mit dem ersten Wellenzahnrad in Eingriff steht, um somit senkrecht zu dem ersten Wellenzahnrad zu sein, sich im Uhrzeigersinn dreht,
das zweite schrägverzahnte Zahnrad, das mit dem ersten schrägverzahnten Zahnrad in Eingriff steht, sich im Gegenuhrzeigersinn dreht, und
das zweite Wellenzahnrad, das mit dem ersten schrägverzahnten Zahnrad gekoppelt ist, um somit senkrecht zu dem ersten schrägverzahnten Zahnrad zu sein, sich im Uhrzeigersinn dreht.

15. Elektronische Vorrichtung nach Anspruch 13, wobei in einem Vorgang, in dem das erste Gehäuse und das zweite Gehäuse aufgefaltet werden,
sich das erste Wellenzahnrad basierend auf einer axialen Richtung parallel zu der faltbaren Anzeige im Uhrzeigersinn dreht,
das erste schrägverzahnte Zahnrad, das mit dem ersten Wellenzahnrad in Eingriff steht, um somit senkrecht zu dem ersten Wellenzahnrad zu sein, sich im Gegenuhrzeigersinn dreht,das zweite schrägverzahnte Zahnrad, das mit dem ersten schrägverzahnten Zahnrad in Eingriff steht, sich im Uhrzeigersinn dreht, und
das zweite Wellenzahnrad, das mit dem ersten schrägverzahnten Zahnrad gekoppelt ist, um somit senkrecht zu dem ersten schrägverzahnten Zahnrad zu sein, sich im Gegenuhrzeigersinn dreht.

## Revendications

1. Dispositif électronique comprenant :
un affichage pliable 160 ;
un premier boîtier 110 ;
un second boîtier 120 ; et
une structure de charnière 200a ou 200b configurée pour raccorder le premier boîtier et le second boîtier,
dans lequel la structure de charnière comprend :
un premier élément rotatif 211 couplé au premier boîtier ;
un second élément rotatif 212 couplé au second boîtier ;
une première partie de patte 221 raccordée au premier élément rotatif ;
une seconde partie de patte 222 raccordée au second élément rotatif ;
un support fixe 213 sur lequel reposent le premier élément rotatif et le second élément rotatif ;
un engrenage hélicoïdal 233 logé d'un côté du support fixe ;
un premier arbre rotatif 231 couplé à la première partie de patte 221 et un premier engrenage d'arbre 231_1 disposé d'un côté du premier arbre rotatif 231 et en prise avec un côté de l'engrenage hélicoïdal ; et
un second arbre rotatif 232 couplé à la seconde partie de patte 222 et un second engrenage d'arbre 232_1 disposé d'un côté du second arbre rotatif 232 et en prise avec un côté opposé de l'engrenage hélicoïdal ;
dans lequel, en réponse à une rotation du premier élément rotatif, la première partie de patte (221) tourne conjointement au premier élément rotatif tout en coulissant le long d'au moins une partie d'une portion latérale du premier élément rotatif ; et
en réponse à une rotation du second élément rotatif, la seconde partie de patte (222) tourne conjointement au second élément rotatif tout en coulissant le long d'au moins une partie d'une portion latérale du second élément rotatif.

2. Dispositif électronique selon la revendication 1, dans lequel le support fixe comprend :
un premier évidement de rail 213_2a auquel est couplé un premier rail formé sur le premier élément rotatif ;
un second évidement de rail 213_2b auquel est couplé un second rail formé sur le second élément rotatif ;
une ouverture 213_4c dans laquelle repose au moins une portion de l'engrenage hélicoïdal ; et
une première extension 213_4a et une deuxième extension 213_4b espacées l'une de l'autre par un espace prédéterminé pour former l'ouverture et configurées pour guider les portions latérales de l'engrenage hélicoïdal.

3. Dispositif électronique selon la revendication 2, dans lequel l'engrenage hélicoïdal comprend :
un premier corps d'engrenage 233_1 disposé sur une surface faisant face à une direction perpendiculaire à une surface avant de l'affichage pliable, le premier corps d'engrenage 233_1 ayant un motif d'engrenage 233_6 formé sur au moins une portion d'une surface latérale de celui-ci ;
un second corps d'engrenage 233_2 espacé du premier corps d'engrenage par un espace prédéterminé et disposé côte à côte avec le premier corps d'engrenage ; et
une portion de pilier 233_5 disposée entre le premier corps d'engrenage et le second corps d'engrenage.

4. Dispositif électronique selon la revendication 3, dans lequel l'engrenage hélicoïdal comprend en outre :
un trou 233_4 configuré pour pénétrer dans le centre de la portion de pilier ; et
une rainure en forme de courroie 233_3 formée entre le premier corps d'engrenage et le second corps d'engrenage, dans lequel au moins une portion de la première extension et au moins une portion de la deuxième extension sont couplées à la rainure en forme de courroie pour limiter le mouvement de l'engrenage hélicoïdal.

5. Dispositif électronique selon la revendication 4, dans lequel le support fixe comprend :
un premier évidement de montage 213_3a dans lequel repose au moins une portion d'une première portion de montage d'arbre 231_3 configurée pour s'étendre à partir d'une extrémité du premier engrenage d'arbre ;
une troisième extension 213_5a configurée pour guider le premier engrenage d'arbre ;
un second évidement de montage 213_3b dans lequel repose au moins une portion d'une seconde portion de montage d'arbre 232_3 configurée pour s'étendre à partir d'une extrémité du second engrenage d'arbre ; et
une quatrième extension 213_5b configurée pour guider le second engrenage d'arbre.

6. Dispositif électronique selon la revendication 5, comprenant en outre :
un support central 243a couplé au support fixe,
dans lequel le support central comprend :
un corps central 243a_1 ;
une première partie d'aile de support 243a_2 formée d'un côté du corps central, le premier arbre rotatif étant inséré dans la première partie d'aile de support 243a_2 ; et
une seconde partie d'aile de support 243a_3 formée d'un côté opposé du corps central, le second arbre rotatif étant inséré dans la seconde partie d'aile de support 243a_3.

7. Dispositif électronique selon la revendication 6, comprenant en outre :
un boîtier de charnière dans lequel repose au moins une portion de la structure de charnière,
dans lequel le support central comprend en outre un trou central 243a_1a dans lequel au moins une portion d'un élément de fixation configuré pour fixer le corps central au boîtier de charnière est insérée.

8. Dispositif électronique selon la revendication 6, dans lequel le support central comprend en outre :
une partie de montage d'engrenage 243a_4 couplée à l'ouverture entre la première extension 213_4a et la deuxième extension 213_4b et utilisée pour limiter le mouvement de l'engrenage hélicoïdal ; et
une première saillie 243a_22a et une seconde saillie 243a_32a couplées à la troisième extension et à la quatrième extension.

9. Dispositif électronique selon la revendication 1, dans lequel un modèle d'engrenage 231_2a du premier engrenage d'arbre et un modèle d'engrenage 232_2a du second engrenage d'arbre sont formés dans la même direction.

10. Dispositif électronique selon la revendication 9, dans lequel lors d'une opération dans laquelle le premier boîtier et le second boîtier sont pliés, tandis que l'engrenage hélicoïdal tourne dans le sens des aiguilles d'une montre sur la base d'une direction perpendiculaire à une surface avant de l'affichage pliable, le premier engrenage d'arbre tourne dans le sens inverse des aiguilles d'une montre, et le second engrenage d'arbre tourne dans le sens des aiguilles d'une montre.

11. Dispositif électronique selon la revendication 9, dans lequel lors d'une opération dans laquelle le premier boîtier et le second boîtier sont dépliés, tandis que l'engrenage hélicoïdal tourne dans le sens inverse des aiguilles d'une montre sur la base d'une direction perpendiculaire à une surface avant de l'affichage pliable, le premier engrenage d'arbre tourne dans le sens des aiguilles d'une montre, et le second engrenage d'arbre tourne dans le sens inverse des aiguilles d'une montre.

12. Dispositif électronique selon la revendication 1, dans lequel l'engrenage hélicoïdal comprend un premier engrenage hélicoïdal 433_a et un second engrenage hélicoïdal 433b ayant une direction hélicoïdale différente du premier engrenage hélicoïdal.

13. Dispositif électronique selon la revendication 12, dans lequel une direction d'un modèle d'engrenage 431_2a du premier engrenage d'arbre 431_2 adjacent au premier engrenage hélicoïdal et une direction d'un modèle d'engrenage 432_2a du second engrenage d'arbre 432_2 adjacent au second engrenage hélicoïdal diffèrent l'une de l'autre.

14. Dispositif électronique selon la revendication 13, dans lequel dans une opération dans laquelle le premier boîtier et le second boîtier sont pliés,
le premier engrenage d'arbre tourne dans le sens inverse des aiguilles d'une montre sur la base d'une direction axiale parallèle à l'affichage pliable,
le premier engrenage hélicoïdal en prise avec le premier engrenage d'arbre de manière à être perpendiculaire au premier engrenage d'arbre tourne dans le sens des aiguilles d'une montre,
le second engrenage hélicoïdal en prise avec le premier engrenage hélicoïdal tourne dans le sens inverse des aiguilles d'une montre, et
le second engrenage d'arbre couplé au premier engrenage hélicoïdal de manière à être perpendiculaire au premier engrenage hélicoïdal tourne dans le sens des aiguilles d'une montre.

15. Dispositif électronique selon la revendication 13, dans lequel lors d'une opération dans laquelle le premier boîtier et le second boîtier sont dépliés,
le premier engrenage d'arbre tourne dans le sens inverse des aiguilles d'une montre sur la base d'une direction axiale parallèle à l'affichage pliable,
le premier engrenage hélicoïdal en prise avec le premier engrenage d'arbre de manière à être perpendiculaire au premier engrenage d'arbre tourne dans le sens inverse des aiguilles d'une montre,
le second engrenage hélicoïdal en prise avec le premier engrenage hélicoïdal tourne dans le sens des aiguilles d'une montre, et
le second engrenage d'arbre couplé au premier engrenage hélicoïdal de manière à être perpendiculaire au premier engrenage hélicoïdal tourne dans le sens des aiguilles d'une montre.
